(19) Europäisches Patentamt
European Patent Office
Office européen des brevets

(11) **EP 4 510 084 A1**

(12) **EUROPEAN PATENT APPLICATION**
published in accordance with Art. 153(4) EPC

(43) Date of publication:
**19.02.2025 Bulletin 2025/08**

(21) Application number: **23869682.7**

(22) Date of filing: **31.05.2023**

(51) International Patent Classification (IPC):
**G06V 10/40** *(2022.01)*  **G06V 10/762** *(2022.01)*

(52) Cooperative Patent Classification (CPC):
**G06F 30/392; G06F 30/398; G06N 3/0455;
G06N 3/0464; G06N 3/08; G06N 3/084;
G06V 10/40; G06V 10/762; G06V 10/774;
G06V 10/82; G06V 30/414; G06V 30/422**

(86) International application number:
**PCT/CN2023/097408**

(87) International publication number:
**WO 2024/066429 (04.04.2024 Gazette 2024/14)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **26.09.2022 CN 202211176018**

(71) Applicant: **Tencent Technology (Shenzhen)
Company Limited
Shenzhen, Guangdong 518057 (CN)**

(72) Inventors:
• **MA, Xingyu**
Shenzhen, Guangdong 518057 (CN)
• **HAO, Shaogang**
Shenzhen, Guangdong 518057 (CN)
• **ZHANG, Shengyu**
Shenzhen, Guangdong 518057 (CN)

(74) Representative: **EP&C**
**P.O. Box 3241**
**2280 GE Rijswijk (NL)**

(54) **CHIP LAYOUT ENCODER TRAINING METHOD AND DEVICE, AND CHIP LAYOUT SCREENING METHOD AND DEVICE**

(57)    A chip layout encoder training method and device, and a chip layout screening method and device, relating to the technical field of integrated circuits. The chip layout encoder training method comprises: acquiring a sample chip layout and an initial encoder (201); performing geometric transformation on the sample chip layout to obtain at least one reference chip layout (202); extracting sample layout features of the sample chip layout and reference layout features of the reference chip layouts by using the initial encoder (203); and training the initial encoder on the basis of the sample layout features and the reference layout features to obtain a trained encoder (204). By using the methods and the devices, for the chip layouts before and after geometric transformation, a chip layout encoder can output similar layout features, such that the chip layout encoder focuses on extracting a layout feature capable of distinguishing a chip layout type, thereby facilitating subsequent improvement of the accuracy of a clustering result when the chip layout is clustered on the basis of the layout feature.

FIG. 2

## Description

RELATED APPLICATION

This application claims priority to Chinese Patent Application No. 202211176018.8, filed on September 26, 2022 and entitled "TRAINING METHOD AND APPARATUS FOR CHIP LAYOUT ENCODER AND CHIP LAYOUT SCREENING METHOD AND APPARATUS".

FIELD OF THE TECHNOLOGY

Embodiments of this application relate to the field of integrated circuit technologies, and in particular, to a training method and apparatus for a chip layout encoder and a chip layout screening method and apparatus.

BACKGROUND OF THE DISCLOSURE

With continuous development of integrated circuit (IC) technologies, a feature size of an IC layout (also referred to as a chip layout) is continuously reduced. The feature size of the chip layout is a minimum size of a semiconductor device. Currently, the feature size of the chip layout has reached a nanometer level.

Generally, a lithography machine needs to be invoked to expose the chip layout on photosensitive adhesive by using a source, to obtain a mask layout, and then the lithography machine is invoked to expose the mask layout on a wafer by using the source, to obtain an imaging layout. Because the feature size of the chip layout is less than a source wavelength used in a photolithography process, an interference effect and a diffraction effect are enhanced. Consequently, an imaging layout obtained by exposing the mask layout on the wafer is distorted and blurred. This reduces chip performance and yield. In this case, source mask optimization needs to be performed on the chip layout, to obtain an optimized mask layout, thereby improving chip performance and yield.

When source mask optimization is performed on the chip layout, a layout feature of the chip layout needs to be extracted. Therefore, how to obtain, through training, a chip layout encoder that can extract the layout feature of the chip layout is a problem urgently to be resolved.

SUMMARY

This application provides a training method and apparatus for a chip layout encoder and a chip layout screening method and apparatus, to extract a layout feature of a chip layout and screen chip layouts, where the technical solutions include the following content:

According to one aspect, a method for training a chip layout encoder is provided, performed by an electronic device and including:

obtaining a sample chip layout and an initial encoder;

performing geometric transformation on the sample chip layout to obtain at least one reference chip layout;

extracting a sample layout feature from the sample chip layout and a reference layout feature from each reference chip layout by the initial encoder; and

training the initial encoder based on a layout feature of the sample chip layout and a layout feature of each reference chip layout to obtain a chip layout encoder, the chip layout encoder being configured to extract a layout feature of a chip layout; or training the initial encoder based on the sample layout feature and the reference layout feature to obtain a trained encoder.

According to another aspect, a chip layout screening method is provided, executable by an electronic device and including:

obtaining a plurality of chip layouts and a chip layout encoder (namely, a trained encoder), the chip layout encoder (namely, the trained encoder) being obtained through the foregoing method for training a chip layout encoder;

extracting layout features from the chip layouts by the trained encoder;

clustering the plurality of chip layouts based on the layout features, to obtain a plurality of clusters, each cluster comprising at least one chip layout; and

screening, for each cluster, one or more key chip layouts from chip layouts of the respective cluster.

According to another aspect, an apparatus for training a chip layout encoder is provided, including:

an obtaining module, configured to obtain a sample chip layout and an initial encoder;

a transformation module, configured to perform geometric transformation on the sample chip layout to obtain at least one reference chip layout;

an extraction module, configured to extract a sample layout feature from the sample chip layout and a reference layout feature from each reference chip layout by the initial encoder; and

a training module, configured to train the initial encoder based on the sample layout feature and the reference layout feature to obtain a trained encoder.

According to another aspect, a chip layout screening apparatus is provided, including:

an obtaining module, configured to obtain a plurality of chip layouts and a chip layout encoder (namely, a trained encoder), the chip layout encoder (namely, the trained encoder) being obtained through the foregoing method for training a chip layout encoder; an extraction module, configured to extract layout features from the chip layouts by the trained encoder;

a clustering module, configured to cluster the plurality of chip layouts based on the layout features, to obtain a plurality of clusters, each cluster comprising at least one chip layout; and

a screening module, configured to screen, for each cluster, one or more key chip layouts from chip layouts of the respective cluster.

According to another aspect, an electronic device is provided, including a processor and a memory, the memory storing at least one computer program, and the at least one computer program being loaded and executed by the processor, so that the electronic device implements the foregoing method for training a chip layout encoder or implements the foregoing chip layout screening method.

According to another aspect, a non-volatile computer-readable storage medium is further provided, storing at least one computer program, the at least one computer program being loaded and executed by a processor, so that an electronic device implements the foregoing method for training a chip layout encoder or implements the foregoing chip layout screening method.

According to another aspect, a computer program is further provided, there being at least one computer program, and the at least one computer program being loaded and executed by a processor, so that an electronic device implements the foregoing method for training a chip layout encoder or implements the foregoing chip layout screening method.

According to still another aspect, a computer program product is further provided, having at least one computer program stored therein, the at least one computer program being loaded and executed by a processor, so that an electronic device implements the foregoing method for training a chip layout encoder or implements the foregoing chip layout screening method.

According to the technical solution provided in this application, geometric transformation is performed on the sample chip layout to obtain the reference chip layout, and the initial encoder is trained by using the layout feature of the sample chip layout and the layout feature of the reference chip layout to obtain the chip layout encoder. Therefore, the chip layout encoder can output similar layout features for chip layouts before and after geometric transformation. The chip layouts before and after geometric transformation belong to the same chip layout type. Therefore, the chip layout encoder focuses on extracting a layout feature that can distinguish between chip layout types. This helps improve accuracy of a clustering result and reduces redundancy of a screening result when clustering and screening are subsequently performed on chip layouts based on the layout feature.

BRIEF DESCRIPTION OF THE DRAWINGS

FIG. 1 is a schematic diagram of an implementation environment of a method for training a chip layout encoder or a chip layout screening method according to an embodiment of this application.

FIG. 2 is a flowchart of a method for training a chip layout encoder according to an embodiment of this application.

FIG. 3 is a schematic diagram of performing geometric transformation on a sample chip layout according to an embodiment of this application.

FIG. 4 is a schematic diagram of a Unet framework according to an embodiment of this application.

FIG. 5 is a flowchart of a chip layout screening method according to an embodiment of this application.

FIG. 6 is a schematic diagram of a chip layout encoder and performing clustering and screening based on the chip layout encoder according to an embodiment of this application.

FIG. 7 is a schematic structural diagram of an apparatus for training a chip layout encoder according to an embodiment of this application.

FIG. 8 is a schematic structural diagram of a chip layout screening apparatus according to an embodiment of this application.

FIG. 9 is a schematic structural diagram of a terminal device according to an embodiment of this application.

FIG. 10 is a schematic structural diagram of a server according to an embodiment of this application.

DESCRIPTION OF EMBODIMENTS

To make objectives, technical solutions, and advantages of this application clearer, the following further describes implementations of this application in detail with reference to the accompanying drawings.

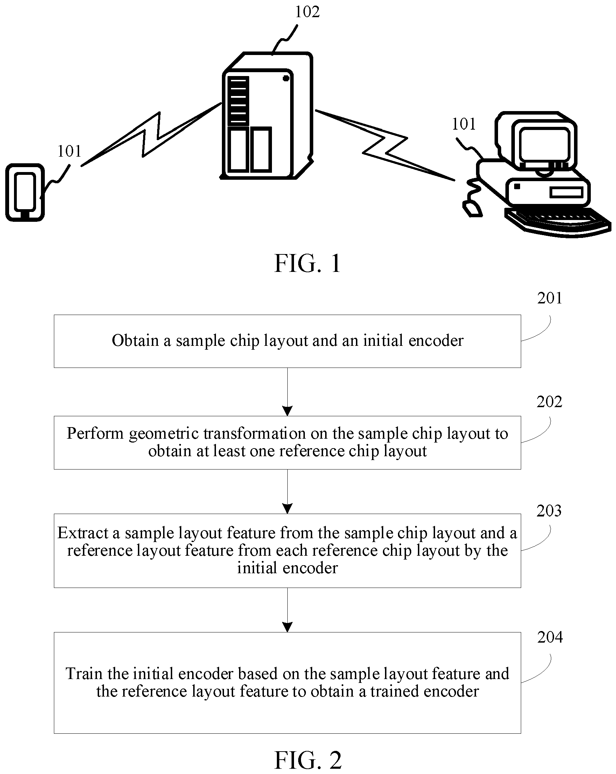

FIG. 1 is a schematic diagram of an implementation environment of a method for training a chip layout encoder or a chip layout screening method according to an embodiment of this application. As shown in FIG. 1, the implementation environment includes a terminal device 101 and a server 102. In all embodiments of the present disclosure, the method for training a chip layout encoder or the chip layout screen method may be performed by the terminal device 101, or may be performed by the server 102, or may be performed jointly by the terminal device 101 and the server 102.

The terminal device 101 may be a smartphone, a game console, a desktop computer, a tablet computer, a laptop portable computer, a smart television, a smart in-vehicle device, a smart voice interaction device, a smart home appliance, or the like. The server 102 may be one server, or a server cluster including a plurality of servers, or any one of a cloud computing platform and a virtualization center. This is not limited in all embodiments of the present disclosure. The server 102 may communicate with the terminal device 101 by using a wired network or a wireless network. The server 102 may have functions such as data processing, data storage, and data sending/receiving. This is not limited in all embodiments of the present disclosure. Quantities of the terminal device 101 and the server 102 are not limited, and there may be one or more terminal devices 101 and one or more servers 102.

The method for training a chip layout encoder or the chip layout screening method provided in all embodiments of the present disclosure may be implemented based on an artificial intelligence technology. Artificial intelligence (AI) is a theory, method, technology, and application system that uses a digital computer or a machine controlled by the digital computer to simulate, extend, and expand human intelligence, perceive an environment, acquire knowledge, and use knowledge to obtain an optimal result. In other words, AI is a comprehensive technology in computer science and attempts to understand the essence of intelligence and produce a new intelligent machine that can react in a manner similar to human intelligence. AI is to study the design principles and implementation methods of various intelligent machines, to enable the machines to have the functions of perception, reasoning, and decision-making.

The AI technology is a comprehensive discipline, and relates to a wide range of fields including both hardware-level technologies and software-level technologies. The basic AI technologies generally include technologies such as a sensor, a dedicated AI chip, cloud computing, distributed storage, a big data processing technology, an operating/interaction system, and electromechanical integration. AI software technologies mainly include several major directions such as a computer vision (CV) technology, a speech processing technology, a natural language processing technology, machine learning (ML)/deep learning, automated driving, and intelligent transportation.

In the field of integrated circuit technologies, an integrated circuit layout is a common layout, and the integrated circuit layout is also referred to as a chip layout. Generally, source mask optimization needs to be performed on the chip layout, to obtain an optimized mask layout, so that an error between the chip layout and an imaging layout obtained by exposing the optimized mask layout on a wafer by using a lithography machine is small, thereby improving chip performance and improving chip yield.

When source mask optimization is performed on the chip layout, a layout feature of the chip layout needs to be extracted. Therefore, how to obtain a chip layout encoder through training to extract the layout feature of the chip layout by using the chip layout encoder becomes a problem urgently to be resolved.

An embodiment of this application provides a method for training a chip layout encoder. The method may be applied to the foregoing implementation environment, and a chip layout encoder may be obtained through training. A flowchart of a method for training a chip layout encoder according to an embodiment of this application shown in FIG. 2 is used as an example. For ease of description, the terminal device 101 or the server 102 that performs the method for training a chip layout encoder in all embodiments of the present disclosure is referred to as an electronic device. The method may be performed by the electronic device. As shown in FIG. 2, the method includes the following steps:

Step 201: Obtain a sample chip layout and an initial encoder.

The sample chip layout is an integrated circuit (IC) layout or a sub-area in the IC layout. Generally, there are a plurality of sample chip layouts, and processing manners of the sample chip layouts are the same.

In the embodiments of the present disclosure including the embodiments of both the claims and the specification (hereinafter referred to as "all embodiments of the present disclosure"), any IC layout may be obtained, and the IC layout is used as a sample chip layout. Alternatively, the IC layout may be evenly divided into several sub-areas to obtain each sub-area, and any sub-area is used as a sample chip layout. In all embodiments of the present disclosure, a part of sub-areas (for example, a sub-area that does not have a defect spot is obtained through screening, and the defect spot is a part that does not meet a process window requirement in the IC layout) may be obtained from the sub-areas through screening according to user's selection, and these sub-areas are used as sample chip layouts. Alternatively, the sub-areas are classified to obtain chip layout types corresponding to the sub-areas, and sub-areas corresponding to the chip layout types are evenly sampled to obtain one or more sample chip layouts through screening. The chip layout types include but are not limited to a contact hole type, a logical layout type, a dense line type, and the like.

It may be understood that a defect spot may be exactly on a division line when the IC layout is evenly divided. In this case, when the IC layout is divided, one defect spot is divided into at least two parts, and different parts are located in different sub-areas. Because the sub-area includes a part of the defect spot, which is an incomplete defect spot, it is difficult to identify the defect spot from the sub-area. Consequently, the sub-area including the defect spot is prone to be used as the sample chip layout, which reduces quality of the sample chip layout.

In all embodiments of the present disclosure, each defect spot on the IC layout may be first identified. A manner of identifying the defect spot is not limited. For example, each defect spot on the IC layout is identified through manual identification, or each defect spot on the IC layout is identified through photolithography simulation. Then, the IC layout is intelligently divided by using an image segmentation model to obtain each sub-area. Through intelligent division, the defect spot is distributed as much as possible in the center of the sub-area instead of an edge of the sub-area. Therefore, when the sample chip layout is obtained from the sub-areas through screening, the defect spot can be quickly and accurately identified from the sub-area, to prevent the sample chip layout obtained through screening from being a sub-area with a defect spot, and improve quality of the sample chip layout. In this way, a training effect of a chip layout encoder can be improved when the chip layout encoder is subsequently trained by using the sample chip layout.

In all embodiments of the present disclosure, the sample chip layout is image data, and belongs to pixel representation. The IC layout is divided and the sample chip layout is obtained through screening, so that various chip layout types such as the contact hole type, the logical layout type, and the dense line type can be represented by using pixels. A pixel size of the sample chip layout needs to be greater than or equal to source wavelength/(4×numeric aperture), that is, the pixel size of the sample chip layout needs to meet minimum resolution of a lithography machine.

The sample chip layout is used for training the initial encoder to obtain the chip layout encoder (i.e., the trained encoder). A structure, a size, and the like of the initial encoder are not limited in all embodiments of the present disclosure. For example, the initial encoder is an encoder in a deep learning framework based on a U network, and is briefly referred to as an encoder in a Unet framework. The encoder in the Unet framework may effectively perform dimension reduction processing on high-dimensional data (for example, image data), to extract a data feature. The Unet framework is a type of convolutional autoencoder, and mainly includes two parts. The first part is an encoder, and includes at least two convolutional blocks. The encoder may be used as the initial encoder in all embodiments of the present disclosure. The second part is a decoder, and includes at least two deconvolutional blocks, and a quantity of convolutional blocks is the same as a quantity of deconvolutional blocks.

Step 202: Perform geometric transformation on the sample chip layout to obtain at least one reference chip layout.

Geometric transformation includes at least one type of transformation such as flipping transformation and rotation transformation. At least one type of transformation such as flipping transformation and rotation transformation may be performed on the sample chip layout to obtain the reference chip layout.

In all embodiments of the present disclosure, step 202 includes: flipping the sample chip layout to obtain a symmetric chip layout, and using the symmetric chip layout as one reference chip layout. It may be understood that the symmetric chip layout herein may also be referred to as a sample chip layout obtained by flipping, which is briefly referred to as a flipped chip layout. In other words, flipping is performed on the sample chip layout to obtain the flipped chip layout. The at least one reference chip layout includes the flipped chip layout. The following describes an implementation of the flipping, and details are not described herein again.

In all embodiments of the present disclosure, step 202 includes: rotating the sample chip layout to obtain a rotary chip layout, and using the rotary chip layout as one reference chip layout. It may be understood that the rotary chip layout herein may also be referred to as a sample chip layout obtained after rotation processing, which is briefly referred to as a rotated chip layout. In other words, the sample chip layout is rotated to obtain the rotated chip layout. The at least one reference chip layout includes the rotated chip layout. The following describes an implementation of rotation processing, and details are not described herein again.

In all embodiments of the present disclosure, step 202 includes: flipping the sample chip layout to obtain a symmetric chip layout; rotating the sample chip layout and the symmetric chip layout to obtain two rotary chip layouts; and using the symmetric chip layout and the rotary chip layouts as reference chip layouts. It may be understood that the symmetric chip layout herein may also be referred to as a sample chip layout obtained by flipping, which is briefly referred to as a flipped chip layout. The rotary chip layouts herein may also be referred to as rotated chip layouts. In other words, flipping is performed on the sample chip layout to obtain a flipped chip layout. The sample chip layout and the flipped chip layout are rotated to obtain rotated chip layouts. The at least one reference chip layout includes the flipped chip layout and the rotated chip layouts.

In all embodiments of the present disclosure, flipping may be performed on the sample chip layout based on mirror information, to implement flipping transformation on the sample chip layout, to obtain the symmetric chip layout, and use the symmetric chip layout as the reference chip layout. The mirror information may represent a position, an orientation, and the like of a mirror surface. The orientation of the mirror surface is the same as a normal direction of the mirror surface, and the position of the mirror surface is represented by a position of a reference point (such as a center point) in the mirror surface. When the mirror surface faces a horizontal direction, it indicates that the normal direction of the mirror surface is the horizontal direction. In this case, leftward or rightward flipping may be performed on the sample chip layout. When the mirror surface faces a vertical direction, it indicates that the normal direction of the mirror surface is the vertical direction. In this case, upward or downward flipping may be performed on the sample chip layout.

It may be understood that there is at least one piece of mirror information. For any piece of mirror information, flipping is performed on the sample chip layout based on the mirror information to obtain one symmetric chip layout, and the symmetric chip layout is used as the reference chip layout. In this manner, different reference chip layouts may be determined based on different mirror information, so that there is at least one reference chip layout.

At least one time of rotating may be performed on the sample chip layout based on a rotation parameter, to implement rotation transformation on the sample chip layout to obtain a rotary chip layout obtained after each time of rotating. In other words, the first time of rotating may be performed on the sample chip layout based on the rotation parameter, and a sample chip layout obtained after the first time of rotating is used as a rotary chip layout obtained after the first time of rotating. Then, the second time of rotating is performed, based on the rotation parameter, on the rotary chip layout obtained after the first time of rotation processing, to obtain a rotary chip layout obtained after the second time of rotating. Subsequently, the third time of rotation processing is performed, based on the rotation parameter, on the rotary chip layout obtained after the second time of rotating, to obtain a rotary chip layout obtained after the third time of rotating. As such, at least one time of rotating is implemented on the sample chip layout.

Similarly, at least one time of rotating may be performed on the symmetric chip layout based on a rotation parameter, to implement rotation transformation on the symmetric chip layout to obtain a rotary chip layout obtained after each time of rotating. The rotary chip layout obtained after each time of rotating may be used as each reference chip layout. The rotation parameter is configured for indicating an angle by which rotation needs to be performed in each time of rotating. For example, the rotation parameter is an angle by which rotation needs to be performed in each time of rotating. In this case, one rotary chip layout may be obtained after the sample chip layout is rotated once by the angle, and one rotary chip layout may also be obtained after the symmetric chip layout is rotated once by the angle.

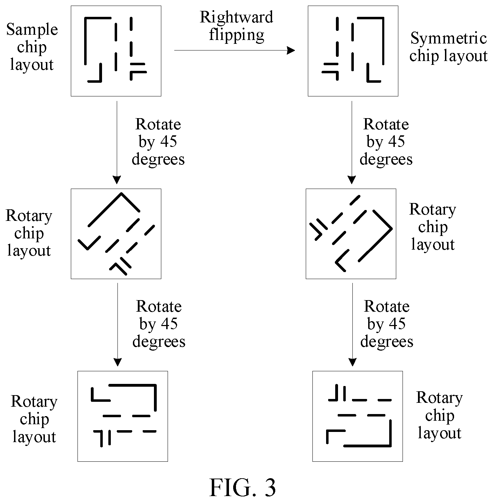

FIG. 3 is a schematic diagram of performing geometric transformation on a sample chip layout according to embodiments of the present disclosure. In all embodiments of the present disclosure, two rotary chip layouts may be obtained after the sample chip layout is rotated once by 45 degrees. In addition, rightward flipping may be first performed on the sample chip layout to obtain a symmetric chip layout, and then two rotary chip layouts are obtained after the symmetric chip layout is rotated once by 45 degrees.

In all embodiments of the present disclosure, the symmetric chip layout and the rotary chip layout may be used as reference chip layouts. It may be understood that rotating may be first performed on the sample chip layout to obtain a rotary chip layout, and then flipping is performed on the sample chip layout and the rotary chip layout to obtain two symmetric chip layouts. Subsequently, the symmetric chip layouts and the rotary chip layout are used as reference chip layouts, and there is at least one reference chip layout. It may be understood that the rotary chip layout herein may also be referred to as a sample chip layout obtained after rotating, which is briefly referred to as a rotated chip layout. The symmetric chip layout herein may also be referred to as flipped chip layouts. In other words, the sample chip layout is rotated to obtain a rotated chip layout. Flipping is performed on the sample chip layout and the rotated chip layout to obtain flipped chip layouts. The at least one reference chip layout includes the rotated chip layout and the flipped chip layouts. The foregoing describes implementations of rotating and flipping, and details are not described herein again.

In all embodiments of the present disclosure, the flipping a chip layout (for example, the sample chip layout, the symmetric chip layout, and the rotary chip layout that are mentioned above) includes: adjusting position information of each pixel in the chip layout based on mirror information, so that adjusted position information of any pixel and position information of the pixel meet mirror symmetry (also be referred to as axial symmetry). A symmetric chip layout obtained after flipping includes adjusted position information of each pixel.

Based on the same principle, rotating a chip layout includes: adjusting position information of each pixel in the chip layout based on a rotation parameter, so that adjusted position information of any pixel and position information of the pixel meet rotation transformation. A rotary chip layout obtained after rotating includes adjusted position information of each pixel.

Therefore, it may be learned that performing geometric transformation on the sample chip layout is adjusting position information of each pixel in the sample chip layout. The reference chip layout includes adjusted position information of each pixel. It may be understood that a neighbor relationship between pixels in the sample chip layout is the same as a neighbor relationship between pixels in the reference chip layout, and the neighbor relationship between pixels is a relationship indicating whether every two pixels are adjacent to each other. In other words, if two pixels in the sample chip layout are adjacent to each other, the two pixels in the reference chip layout are also adjacent to each other.

In all embodiments of the present disclosure, flipping and rotating may be performed on the sample chip layout to obtain a reference chip layout, or rotating may be performed on the symmetric chip layout to obtain a reference chip layout, or flipping may be performed on the rotary chip layout to obtain a reference chip layout. each reference chip layout is determined in one of a plurality of manners, so that diversity of the reference chip layout is improved. Therefore, the chip layout encoder obtained through training by using the reference chip layout has a strong generalization capability, and a representation capability of a layout feature can be improved, so that accuracy of a clustering result can be improved when clustering is performed on chip layouts based on the layout feature. Especially, the reference chip layouts are obtained through various geometric transformations, which can be used to train the encoder with the ability to output similar layout features for chip layouts before and after geometric transformation.

Step 203: Extract a sample layout feature from the sample chip layout and a reference layout feature from each reference chip layout by the initial encoder.

In all embodiments of the present disclosure, the sample layout feature may be referred to as a layout feature of the sample chip layout, and the reference layout feature may be referred to as a layout feature of the reference chip layout. Extracting the layout feature by using the initial encoder is equivalent to extracting the layout feature via the initial encoder. In all embodiments of the present disclosure, step 203 may include: extracting the layout feature from the sample chip layout and the layout feature from each reference chip layout via the initial encoder.

In all embodiments of the present disclosure, the sample chip layout may be inputted into the initial encoder, and the initial encoder performs feature extraction on the sample chip layout to obtain the layout feature of the sample chip layout. Similarly, for any reference chip layout, the reference chip layout may be inputted into the initial encoder, and the initial encoder performs feature extraction on the reference chip layout to obtain a layout feature of the reference chip layout. The following focuses on a manner in which the initial encoder performs feature extraction on the sample chip layout. A manner in which the initial encoder performs feature extraction on the reference chip layout is similar to the manner in which the initial encoder performs feature extraction on the sample chip layout, and details are not described below.

In all embodiments of the present disclosure, "extracting a layout feature from the sample chip layout by the initial encoder" in step 203 includes: performing a plurality of times of downsampling on the sample chip layout via the initial encoder (that is, by using the initial encoder), to obtain the sample layout feature being a downsampling feature obtained through a last time of downsampling. A downsampling feature is obtained through each time of downsampling, and the layout feature, namely, the sample layout feature, of the sample chip layout is a downsampling feature obtained through the last time of downsampling.

In all embodiments of the present disclosure, the initial encoder includes at least two convolutional blocks, and input of a current convolutional block is output of a previous convolutional block. Based on this, the sample chip layout is inputted into the initial encoder, a plurality of times of downsampling are performed by using the at least two convolutional blocks, and output of each convolutional block is a downsampling feature. In all embodiments of the present disclosure, compared with input of each convolutional block, a feature size of output of the convolutional block is reduced by half, and a channel quantity thereof doubles. Final output of the initial encoder may be a one-dimensional feature vector, for example, a dimension of the one-dimensional feature vector is (1, 1, 1024). The one-dimensional feature vector is the layout feature of the sample chip layout.

In an exemplary embodiment, "performing a plurality of times of downsampling on the sample chip layout by using the initial encoder, to obtain each downsampling feature" includes: performing the first time of downsampling on the sample chip layout by using the initial encoder, to obtain a first downsampling feature; and performing, for each downsampling feature obtained through a respective time of downsampling, a next time of downsampling on the respective downsampling feature by the initial encoder, to obtain a downsampling feature obtained through the next time of downsampling processing.

In other words, after the sample chip layout is inputted into the initial encoder, the initial encoder may map the sample chip layout into an initial feature, and perform downsampling on the initial feature of the sample chip layout by using the first convolutional block in the at least two convolutional blocks, to obtain the first downsampling feature. Then, downsampling is performed on the first downsampling feature by using the second convolutional block in the at least two convolutional blocks, to obtain the second downsampling feature, and so on. The process continues until the last downsampling feature is obtained, and the last downsampling feature is used as the layout feature of the sample chip layout.

In other words, after the sample chip layout is inputted into the initial encoder, downsampling is performed, by using the first convolutional block in the at least two convolutional blocks, on the initial feature obtained by mapping the sample chip layout, to obtain the first downsampling feature. For an $i^{th}$ convolutional block (i is a positive integer greater than 1), downsampling is performed on an $(i-1)^{th}$ downsampling feature by using the $i^{th}$ convolutional block, to obtain an $i^{th}$ downsampling feature. It is assumed that there are M convolutional blocks in total. In this case, an $M^{th}$ downsampling feature obtained by using an $M^{th}$ convolutional block is the layout feature of the sample chip layout.

A plurality of times of downsampling are performed on the sample chip layout, so that a dimension of the downsampling feature is continuously reduced, and a representation capability of the downsampling feature is improved, that is, a representation capability of the layout feature of the sample chip layout is improved.

In all embodiments of the present disclosure, one convolutional block includes one convolutional layer, the convolutional layer includes at least one 3×3 filter, and a quantity of filters included in a previous convolutional block is less than a quantity of filters included in a current convolutional block. The convolution layer is configured for performing convolution on the initial feature of the sample chip layout or the downsampling feature to obtain a convolved feature. If the convolutional block includes only the convolutional layer, the convolution is equivalent to downsampling processing, and the convolved feature is equivalent to a downsampling feature.

In all embodiments of the present disclosure, one convolutional block includes a convolutional layer and a batch normalization layer that are connected in series. The batch normalization layer is configured for performing batch normalization on a convolved feature to obtain a batch normalization feature. If the convolutional block includes only the convolutional layer and the batch normalization layer, the downsampling includes convolution and batch normalization processing, and the batch normalization feature is equivalent to a downsampling feature.

In all embodiments of the present disclosure, one convolutional block includes a convolutional layer, a batch normalization layer, and an activation layer that are connected in series. The activation layer is configured for performing activation on a batch normalization feature to obtain an activation feature. If the convolutional block includes only the convolutional layer, the batch normalization layer, and the activation layer, the downsampling includes convolution processing, batch normalization processing, and activation processing, and the activation feature is equivalent to a downsampling feature. The activation layer may use a rectified linear unit (ReLU).

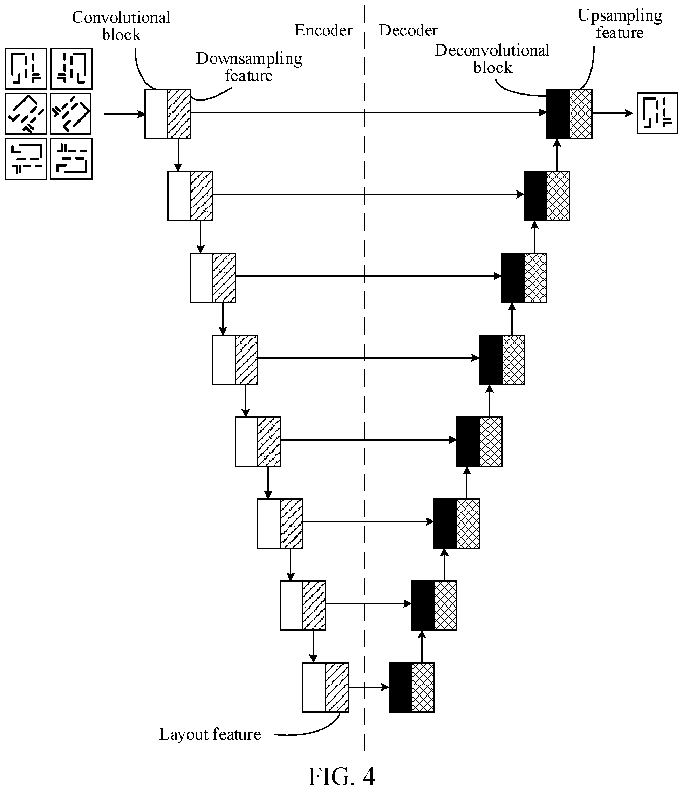

FIG. 4 is a schematic diagram of a Unet framework according to an embodiment of this application. The Unet framework includes an encoder, and the encoder is the initial encoder in all embodiments of the present disclosure. The encoder includes eight convolutional blocks, and each convolutional block includes a convolutional layer, a batch normalization layer, and an activation layer that are connected in series, and the activation layer uses a rectified linear unit. The eight convolutional blocks successively include 8, 16, 32, 64, 128, 256, 512, and 1024 3×3 filters.

FIG. 4 shows the sample chip layout, the symmetric chip layout, and the rotary chip layout that are shown in FIG. 3. These layouts are all inputted into the Unet framework, and layout features of these layouts are extracted by the encoder included in the Unet framework.

The sample chip layout is used as an example. The sample chip layout is inputted into the Unet framework, and the encoder included in the Unet framework performs eight times of downsampling on the sample chip layout to obtain eight downsampling features. It is assumed that a size of the sample chip layout is (256, 256, 1). In this case, sizes of the eight downsampling features are respectively (128, 128, 8), (64, 64, 16), (32, 32, 32), (16, 16, 64), (8, 8, 128), (4, 4, 256), and (1, 1, 1024). The last downsampling feature is the layout feature of the sample chip layout. Therefore, a size of the layout feature of the sample chip layout is (1, 1, 1024), and is a one-dimensional feature vector.

Step 204: Train the initial encoder based on the sample layout feature and the reference layout feature to obtain a trained encoder.

It may be understood that the trained encoder may also be referred to as a chip layout encoder. Based on this, step 204 may be described as follows: training the initial encoder based on the layout feature of the sample chip layout and the layout feature of each reference chip layout to obtain a chip layout encoder.

In all embodiments of the present disclosure, the trained encoder is configured to generate a chip layout and/or extracting a feature of a chip layout.

In all embodiments of the present disclosure, a first loss may be determined based on the layout feature of the sample chip layout and the layout feature of each reference chip layout. In all embodiments of the present disclosure, for any reference chip layout, a distance between the layout feature of the reference chip layout and the layout feature of the sample chip layout may be calculated, the distance is referred to as a distance corresponding to the reference chip layout, weighted calculation (for example, weighted summation and weighted averaging) is performed on distances corresponding to the reference chip layouts, and a weighted calculation result is used as the first loss. Alternatively, averaging calculation may be performed on the layout features of the reference chip layouts to obtain an average layout feature, a distance between the average layout feature and the layout feature of the sample chip layout is calculated, and the distance is used as the first loss. Therefore, the first loss may indicate difference the layout feature of the sample chip layout and the layout feature of each reference chip layout.

For example, averaging calculation may be performed on the layout features of the reference chip layouts by using the following Formula (1), to obtain the average layout feature:

$$\overline{\text{Encoder}(\widehat{T}x_i)} = \frac{1}{K}\sum_{n}^{K}\text{Encoder}(\widehat{T_n}x_i) \quad \text{Formula (1)}$$

where $x_i$ represents an $i^{th}$ sample chip layout, $\widehat{T_n}x_i$ represents a reference chip layout obtained after an nth time of geometric transformation is performed on the $i^{th}$ sample chip layout, and K represents a total quantity of times of geometric transformation, and also represents a quantity of reference chip layouts. For one sample chip layout, performing one time of flipping on the sample chip layout and a rotary chip layout is equivalent to performing one time of geometric transformation on the sample chip layout to obtain a symmetric chip layout. Rotating the sample chip layout, the symmetric chip layout, and the rotary chip layout by the angle is equivalent to performing one time of geometric transformation on the sample chip layout to obtain a rotary chip layout. If one time of leftward mirror flipping and one time of rightward mirror flipping are performed on one sample chip layout to obtain two symmetric chip layouts, and the two symmetric chip layouts are rotated once by 45 degrees, a total quantity of times of rotation is 14, and 14 rotary chip layouts may be obtained. Both the symmetric chip layouts and the rotary chip layouts are used as reference chip layouts. Therefore, a quantity of reference chip layouts is 16, and a value of K is 16.

In addition, in Formula (1), Encoder represents a feature extraction operation, and $\Sigma$ represents a symbol of a summation function. Therefore, $\overline{\text{Encoder}(\widehat{T}x_i)}$ represents the average layout feature, and $\text{Encoder}(\widehat{T_n}x_i)$ represents a layout feature of the reference chip layout obtained after the nth time of geometric transformation is performed on the $i^{th}$ sample chip layout.

Based on Formula (1), the distance between the average layout feature and the layout feature of the sample chip layout may be calculated by using the following Formula (2), to obtain the first loss:

$$\text{Loss}_{\text{rotation}} = \sum_{i=0}^{N}|\text{Encoder}(x_i) - \overline{\text{Encoder}(\widehat{T}x_i)}|^2 \quad \text{Formula (2)}$$

where $\text{Loss}_{\text{rotation}}$ represents the first loss, $\text{Encoder}(x_i)$ represents a layout feature of the $i^{th}$ sample chip layout, a total quantity of sample chip layouts is N+1, and $\Sigma$ represents a symbol of a summation function.

After the first loss is calculated, the first loss may be used as a loss of the initial encoder, and the initial encoder is trained by using the loss of the initial encoder in a gradient descent manner to obtain the trained initial encoder. Training the initial encoder is adjusting a weight and a bias of a neuron in the initial encoder, to reduce the loss of the initial encoder. If the trained initial encoder meets a training end condition, the trained initial encoder is used as the chip layout encoder (namely, the trained encoder). If the trained initial encoder does not meet the training end condition, the trained initial encoder is used as an initial encoder in a next time training, and the next time of training is performed on the initial encoder based on the method for training a chip layout encoder provided In all embodiments of the present disclosure, until the chip layout encoder is obtained.

That the training end condition is met is not limited in all embodiments of the present disclosure. For example, that the training end condition is met is that a quantity of times of training reaches a preset quantity (for example, 500 times). Alternatively, when the initial encoder is trained by using the loss of the initial encoder in a gradient descent manner, a gradient of the loss of the initial encoder needs to be determined, and a parameter of the initial encoder is adjusted based on the gradient, so that a gradient that is of a loss of an initial encoder determined and that is in a next time of training is less than the gradient that is of the loss of the initial encoder and that is determined in the current time of training. When a gradient difference between the gradient that is of the loss of the initial encoder and that is determined in the next time of training and the gradient that is of the loss of the initial encoder and that is determined in the current time of training is less than a difference threshold, it is determined that the training end condition is met. In other words, the gradient that is of the loss of the initial encoder and that is determined in the next time of training is subtracted from the gradient that is of the loss of the initial encoder and that is determined in the current time of training, to obtain the gradient difference. If the gradient difference is less than the difference threshold, the training end condition is met. In this case, that the training end condition is met is equivalent to that a descent range of the gradient of the loss of the initial encoder falls within a range of the difference threshold. A manner of determining the difference threshold is not limited in all embodiments of the present disclosure. For example, the difference threshold is determined based on manual experience, or a data range is manually set, and the difference threshold is randomly generated data falling within the data range.

Because the first loss is determined based on the layout feature of the sample chip layout and the layout feature of each reference chip layout, the initial encoder may be trained by using the first loss, so that the layout feature of the sample chip layout and the layout feature of the reference chip layout that are extracted by the initial encoder are close to each other. Because the reference chip layout is obtained by performing geometric transformation on the sample chip layout, the reference chip layout and the sample chip layout belong to the same type of chip layout. In a process of training the initial encoder, a layout feature extracted by the initial encoder may continuously tend to represent a chip layout category, so that a finally trained chip layout encoder focuses on extracting a layout feature that can represent a chip layout category. The layout feature extracted by the chip layout encoder may represent a chip layout before geometric transformation and a chip layout after geometric transformation, so that the layout feature extracted by the chip layout encoder has a property of invariance before and after geometric transformation. Therefore, the first loss is a loss that may represent invariance before and after geometric transformation.

In a possible implementation, the method for training a chip layout encoder further includes step 205. Step 205 is performed after step 203.

Step 205: Determine a reconstructed chip layout based on the layout feature of the sample chip layout. That is, the reconstructed chip layout is determined from the sample layout feature, and the reconstructed chip layout is a chip layout reconstructed from the layout feature of the sample chip layout.

In all embodiments of the present disclosure, the layout feature of the sample chip layout may be inputted into the initial decoder, and a new chip layout is reconstructed by the initial decoder based on the layout feature of the sample chip layout, to obtain the reconstructed chip layout. In all embodiments of the present disclosure, a structure, a size, and the like of the initial decoder are not limited. For example, the initial decoder is a decoder in the Unet framework.

In all embodiments of the present disclosure, step 205 includes: performing a plurality of times of upsampling on the layout feature of the sample chip layout to obtain each upsampling feature, each upsampling feature being an upsampling feature obtained through each time of upsampling; or performing a plurality of times of upsampling on the sample layout feature to obtain an upsampling feature obtained through each time of upsampling, the reconstructed chip layout being a chip layout obtained based on an upsampling feature obtained through the last time of upsampling processing.

In all embodiments of the present disclosure, the initial decoder includes at least two deconvolutional blocks, and output of a previous deconvolutional block is input of a current deconvolutional block. In all embodiments of the present disclosure, compared with input of each deconvolutional block, a feature size of output of the deconvolutional block doubles, and a quantity of channels thereof is reduced by half. A feature size finally outputted by the initial decoder is consistent with the size of the sample chip layout inputted into the initial encoder.

In other words, after the layout feature of the sample chip layout is inputted into the initial decoder, upsampling is performed on the layout feature of the sample chip layout by using the first deconvolutional block in the at least two deconvolutional blocks, to obtain a first upsampling feature. Then, upsampling is performed on the first upsampling feature by using the second deconvolutional block in the at least two deconvolutional blocks, to obtain the second upsampling feature, and so on. The process continues until the last upsampling feature is obtained, the last upsampling feature may be mapped into a chip layout, and the chip layout is the reconstructed chip layout.

In other words, after the layout feature of the sample chip layout is inputted into the initial decoder, upsampling is performed on the layout feature of the sample chip layout by using the first deconvolutional block in the at least two deconvolutional blocks, to obtain the first upsampling feature. For an $i^{th}$ deconvolutional block ($i$ is a positive integer greater than 1), upsampling is performed on an $(i-1)^{th}$ upsampling feature by using the $i^{th}$ deconvolutional block, to obtain an $i^{th}$ upsampling feature. It is assumed that there are M deconvolutional blocks in total. In this case, an $M^{th}$ upsampling feature obtained by using an $M^{th}$ deconvolutional block may be mapped into the reconstructed chip layout.

In all embodiments of the present disclosure, one deconvolutional block includes one deconvolutional layer, the deconvolutional layer includes at least one $3 \times 3$ filter, and a quantity of filters included in a previous deconvolutional block is greater than a quantity of filters included in a current deconvolutional block. The deconvolution layer is configured for performing deconvolution on the layout feature of the sample chip layout or the upsampling feature to obtain a deconvolved feature. If the deconvolutional block includes only the deconvolutional layer, the deconvolution is equivalent to upsampling processing, and the deconvolved feature is equivalent to an upsampling feature.

In all embodiments of the present disclosure, one deconvolutional block includes a deconvolutional layer and a batch normalization layer that are connected in series. The batch normalization layer is configured for performing batch normalization on a deconvolved feature to obtain a batch normalization feature. If the deconvolutional block includes only the deconvolutional layer and the batch normalization layer, the upsampling includes deconvolution processing and batch normalization processing, and the batch normalization feature is equivalent to an upsampling feature.

In all embodiments of the present disclosure, one deconvolutional block includes a deconvolutional layer, a batch normalization layer, and an activation layer that are connected in series. The activation layer is configured for performing activation processing on a batch normalization feature to obtain an activation feature. If the deconvolutional block includes only the deconvolutional layer, the batch normalization layer, and the activation layer, the upsampling processing includes deconvolution processing, batch normalization processing, and activation processing, and the activation feature is equivalent to an upsampling feature. The activation layer may use a Leaky-ReLU activation function or a sigmoid activation function.

In all embodiments of the present disclosure, the performing a plurality of times of upsampling on the layout feature of the sample chip layout to obtain each upsampling feature includes step A1 to step A4 that are shown below:

Step A1: Perform the first time of upsampling on the layout feature (namely, the sample layout feature) of the sample chip layout to obtain a first upsampling feature, the layout feature (namely, the sample layout feature) of the sample chip layout being obtained by performing a plurality of times of downsampling on the sample chip layout.

In step 203, content that a plurality of times of downsampling are performed on the sample chip layout to obtain the layout feature of the sample chip layout has been mentioned, and details are not described herein again. In all embodiments of the present disclosure, after the layout feature of the sample chip layout is inputted into the initial decoder, upsampling is performed on the layout feature of the sample chip layout by using the first deconvolutional block in the at least two deconvolutional blocks, to obtain the first upsampling feature.

In all embodiments of the present disclosure, step A2: Obtain, for each upsampling feature obtained through a respective time of upsampling processing, a downsampling feature corresponding to the respective upsampling feature. A quantity of times of downsampling, in a case that downsampling is performed on the sample chip layout to obtain the downsampling feature corresponding to the respective upsampling feature, is a first quantity of times, and a quantity of times of upsampling, in a case that upsampling is performed on the layout feature (namely, the sample layout feature) of the sample chip layout to obtain the respective upsampling feature, is a second quantity of times, and a sum of the first quantity of times and the second quantity of times being a preset quantity of times. In all embodiments of the present disclosure, step A2: obtain, for each upsampling feature obtained through a respective time of upsampling, a downsampling feature corresponding to the respective upsampling feature, the downsampling feature corresponding to the respective upsampling feature being obtaining by a jth time of downsampling in the plurality of times of downsampling, the respective time of upsampling being an ith time of upsampling, a sum of i and j being a preset quantity of times. It is assumed that there are M deconvolutional blocks in total, the preset quantity of times is M. Wherein each of i, j and M is a positive integer greater than or equal to 1.

In all embodiments of the present disclosure, a quantity of convolutional blocks in the initial encoder is the same as a quantity of deconvolutional blocks in the initial decoder. Therefore, a total quantity of times that the initial encoder performs downsampling is the same as a total quantity of times that the initial decoder performs upsampling processing. The preset quantity of times is the total quantity of times that the initial encoder performs downsampling. For example, if the initial encoder performs eight times of downsampling in total, the preset quantity of times is 8.

In all embodiments of the present disclosure, for an $i^{th}$ upsampling feature (i is a positive integer greater than or equal to 1) obtained through an $i^{th}$ time of upsampling processing, the second quantity of times is i. The sum of the first quantity of times and the second quantity of times is the preset quantity of times. Therefore, if the preset quantity of times is M, the first quantity of times is M-i. It may be determined that a downsampling feature corresponding to the $i^{th}$ upsampling feature is: an $(M-i)^{th}$ downsampling feature obtained by performing an $(M-i)^{th}$ time of downsampling on the sample chip layout.

For example, if the preset quantity of times is 8, a downsampling feature corresponding to the first upsampling feature is the seventh downsampling feature, a downsampling feature corresponding to the second upsampling feature is the sixth downsampling feature, and so on.

Step A3: Combine the respective upsampling feature with the downsampling feature corresponding to the respective upsampling feature, to obtain a combined feature corresponding to the respective upsampling feature.

The $i^{th}$ upsampling feature may be combined with the $(M-i)^{th}$ downsampling feature to obtain a combined feature corresponding to the $i^{th}$ upsampling feature.

Step A4: Perform upsampling on the combined feature corresponding to the respective upsampling feature, to obtain a next upsampling feature of the respective upsampling feature.

Upsampling is performed on the combined feature corresponding to the $i^{th}$ upsampling feature, to obtain an $(i+1)^{th}$ upsampling feature.

When the last upsampling feature is obtained, the last upsampling feature may be mapped into the reconstructed chip layout, or the last upsampling feature and the first downsampling feature may be combined to obtain a combined feature corresponding to the last upsampling feature, and the combined feature corresponding to the last upsampling feature is mapped into the reconstructed chip layout.

Referring to FIG. 4, the Unet framework shown in FIG. 4 includes a decoder, and the decoder is the initial decoder in all embodiments of the present disclosure. The decoder includes eight deconvolutional blocks, and each deconvolutional block includes a deconvolutional layer, a batch normalization layer, and an activation layer that are connected in series. The eight deconvolutional blocks successively include 1024 $3\times3$ filters, 512 $3\times3$ filters, 256 $3\times3$ filters, 128 $3\times3$ filters, 64 $3\times3$ filters, 32 $3\times3$ filters, 16 $3\times3$ filters, and 1 $3\times3$ filter. Activation layers in the first seven deconvolutional blocks are Leaky-ReLU activation functions, and an activation layer in the eighth deconvolutional block is a sigmoid activation function. The encoder in the Unet framework has been described above, and details are not described herein again.

In all embodiments of the present disclosure, the encoder in the Unet framework may perform eight times of downsampling on the sample chip layout, to obtain eight downsampling features; perform upsampling on the eighth downsampling feature to obtain the first upsampling feature; obtain the second upsampling feature based on the first upsampling feature and the seventh downsampling feature; obtain the third upsampling feature based on the second upsampling feature and the sixth downsampling feature, and so on, until the eighth upsampling feature is obtained based on the seventh upsampling feature and the first downsampling feature.

When the second upsampling feature is obtained based on the first upsampling feature and the seventh downsampling feature, the first upsampling feature may be combined with the seventh downsampling feature to obtain a combined feature corresponding to the first upsampling feature, and upsampling is performed on the combined feature corresponding to the first upsampling feature, to obtain the second upsampling feature. Manners of determining the third upsampling feature to the eighth upsampling feature are similar to the manner of determining the second upsampling feature, and details are not described herein again.

It is assumed that the size of the layout feature of the sample chip layout is (1, 1, 1024), and is a one-dimensional feature vector. In this case, sizes of the eight upsampling features are successively (2, 2, 1024), (4, 4, 512), (8, 8, 256), (16, 16, 128), (32, 32, 64), (64, 64, 32), (128, 128, 16), and (256, 256, 1). A size of the reconstructed chip layout obtained based on the eighth upsampling feature is (256, 256, 1), and is consistent with the size of the sample chip layout.

In all embodiments of the present disclosure, determining a next upsampling feature of any upsampling feature based on the upsampling feature and a downsampling feature corresponding to the upsampling feature is essentially splicing output of a convolutional block in the initial encoder with output of a deconvolutional block in the initial decoder together as input of a next deconvolutional block. This can improve a representation capability of an upsampling feature obtained after upsampling is performed by using the deconvolutional block, thereby improving accuracy of the reconstructed chip layout, and making the reconstructed chip layout close to the sample chip layout.

In all embodiments of the present disclosure, the reconstructed chip layout outputted by the initial decoder is a binary mask layout. The binary mask map includes a plurality of pixels, and a value of each pixel indicates that the pixel is transparent or opaque. In all embodiments of the present disclosure, if a value of a pixel is a first value, it indicates that the pixel is transparent; or if a value of a pixel is a second value, it indicates that the pixel is opaque. The first value is any value, for example, the first value is 0. The second value is any value different from the first value, for example, the second value is 1. In other words, if the first value is 0 and the second value is 1, when a value of a pixel on the binary mask map is 1, it indicates that the pixel is opaque; or when a value of a pixel on the binary mask map is 0, it represents that the pixel is transparent.

When the reconstructed chip layout may be obtained, step 204 includes: training the initial encoder based on the sample chip layout, the reconstructed chip layout, the layout feature (namely, the sample layout feature) of the sample chip layout, and the layout feature (namely, the reference layout feature) of each reference chip layout, to obtain the chip layout encoder (namely, the trained encoder).

A loss of the initial encoder may be determined based on the sample chip layout, the reconstructed chip layout, the layout feature of the sample chip layout, and the layout feature of each reference chip layout. The initial encoder is trained by using the loss of the initial encoder to obtain the chip layout encoder.

In all embodiments of the present disclosure, the training the initial encoder based on the sample chip layout, the reconstructed chip layout, the layout feature of the sample chip layout, and the layout feature of each reference chip layout, to obtain the chip layout encoder includes the following steps B1 to B3.

Step B1: Determine a first loss based on the layout feature (namely, the sample layout feature) of the sample chip layout and the layout feature (namely, the reference layout feature) of each reference chip layout. A process of determining the first loss has been described in step 204, and details are not described herein again.

Step B2: Determine a second loss based on the sample chip layout and the reconstructed chip layout.

In all embodiments of the present disclosure, a distance between the sample chip layout and the reconstructed chip layout may be obtained by comparing the sample chip layout with the reconstructed chip layout at a pixel level, and the distance is used as the second loss. Therefore, the second loss may indicate difference between the sample chip layout and the reconstructed chip layout.

In all embodiments of the present disclosure, the second loss is determined by using the following Formula (3):

$$\text{Loss}_{\text{rebuild}} = \sum_{i=0}^{N} |x_i - x_{i(\text{pred})}|^2 \qquad \text{Formula (3)}$$

where $\text{Loss}_{\text{rebuild}}$ represents the second loss, $x_i$ represents an $i^{th}$ sample chip layout, $x_{i(\text{pred})}$ represents a reconstructed chip layout corresponding to the $i^{th}$ sample chip layout, a total quantity of sample chip layouts is N+1, and $\Sigma$ represents a symbol of a summation function.

Step B3: Train the initial encoder based on the first loss and the second loss to obtain the chip layout encoder (namely, the trained encoder).

In all embodiments of the present disclosure, operation processing such as summation, weighted summation, averaging, and weighted averaging may be performed on the first loss and the second loss, and an operation processing result is determined as the loss of the initial encoder, for example, the loss of the initial encoder is $\text{Loss} = \text{Loss}_{\text{rebuild}} + \text{Loss}_{\text{rotation}}$. The initial encoder is trained by using the loss of the initial encoder to obtain the chip layout encoder.

Since the second loss is determined based on the sample chip layout and the reconstructed chip layout, the initial encoder is trained by using the second loss. In this way, after the layout feature of the sample chip layout is extracted via the initial encoder, the reconstructed chip layout that is closer to the sample chip layout can be reconstructed via the initial decoder based on the layout feature of the sample chip layout, thereby ensuring that the layout feature of the sample chip layout can accurately represent the sample chip layout, and improving accuracy of the layout feature of the sample chip layout.

In a process of training the initial encoder by using the loss of the initial encoder, the initial decoder may also be synchronously trained by using the loss of the initial encoder, to improve a training effect. During application, a reconstructed chip layout may be determined based on the layout feature of the reference chip layout. The reconstructed chip layout is a chip layout reconstructed based on the layout feature of the reference chip layout. A third loss is determined by using the reference chip layout and the reconstructed chip layout. The third loss may indicate difference between the reference chip layout and the reconstructed chip layout. A loss of the initial encoder is determined by using at least one of the first loss, the second loss, and the third loss, to train the initial encoder by using the loss of the initial encoder, to obtain the chip layout encoder. A manner of determining the reconstructed chip layout is similar to a manner of determining the reconstructed chip layout, and a manner of determining the third loss is similar to a manner of determining the second loss. Details are not described herein again.

Information (including but not limited to user device information, user personal information, and the like), data (including but not limited to data used for analysis, stored data, and displayed data), and a signal in this application are authorized by a user or fully authorized by each party, and related data needs to be collected, used, and processed in compliance with relevant national laws and standards. For example, the sample chip layout in this application is obtained in case of full authorization.

According to the foregoing method, geometric transformation is performed on the sample chip layout to obtain the reference chip layout, and the initial encoder is trained by using the layout feature of the sample chip layout and the layout feature of the reference chip layout to obtain the chip layout encoder. Therefore, the chip layout encoder can output similar layout features for chip layouts before and after geometric transformation. The chip layouts before and after geometric transformation belong to the same chip layout type. Therefore, the chip layout encoder focuses on extracting a layout feature that can distinguish between chip layout types. This helps improve accuracy of a clustering result and reduces redundancy of a screening result when clustering processing and screening processing are subsequently performed on chip layouts based on the layout feature.

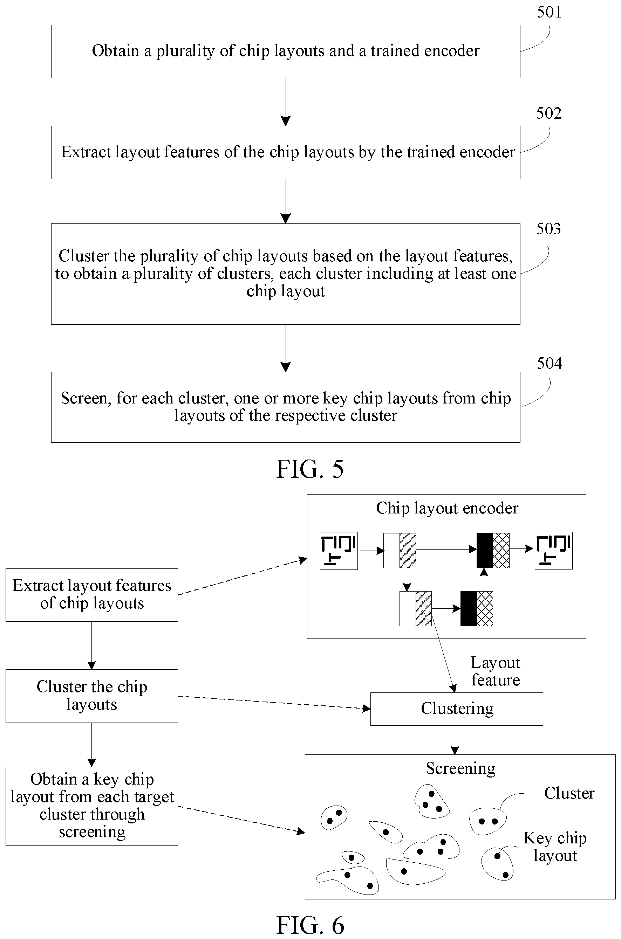

An embodiment of this application further provides a chip layout screening method. The method may be applied to the foregoing implementation environment, so that a key chip layout can be accurately obtained from a plurality of chip layouts through screening. A flowchart of a chip layout screening method according to an embodiment of this application shown in FIG. 5 is used as an example. For ease of description, the terminal device 101 or the server 102 that performs the chip layout screening method in all embodiments of the present disclosure is referred to as an electronic device. The method may be performed by the electronic device. As shown in FIG. 5, the method includes the following steps:

Step 501: Obtain a plurality of chip layouts and a trained encoder.

The trained encoder may also be referred to as a chip layout encoder. Step 501 may be described as follows: obtaining a plurality of chip layouts and a chip layout encoder.

In all embodiments of the present disclosure, any chip layout is an IC layout or a sub-area obtained by dividing the IC layout. A manner of determining the chip layout is the same as a manner of determining a sample chip layout. For details, refer to descriptions of step 201. Details are not described herein again. The chip layout encoder is obtained through training based on the method for training a chip layout encoder related to FIG. 2. For details, refer to related descriptions of step 201 to step 205. Details are not described herein again.

Step 502: Extract layout features of the chip layouts by the trained encoder.

The layout feature may also be referred to as a layout feature of the chip layout. Step 502 may also be described as follows: extracting layout features of the chip layouts by the chip layout encoder.

Any chip layout is inputted into the chip layout encoder, and the chip layout encoder performs feature extraction on the chip layout to obtain a layout feature of the chip layout. A manner of determining the layout feature of the chip layout is similar to a manner of determining a layout feature of the sample chip layout. For details, refer to related descriptions of step 203. Details are not described herein again.

Step 503: Cluster the plurality of chip layouts based on the layout features, to obtain a plurality of clusters, each cluster including at least one chip layout.

The layout feature of the chip layout may represent the chip layout. The layout features of the chip layouts are calculated, so that the plurality of chip layouts can be clustered into a plurality of clusters.

In all embodiments of the present disclosure, for any two chip layouts, a distance between layout features of the two chip layouts may be calculated according to a distance formula. If the distance between the layout features of the two chip layouts is less than a distance threshold, it indicates that the two chip layouts are similar, and the two chip layouts are clustered into the same initial cluster. If the distance between the layout features of the two chip layouts is not less than the distance threshold, it indicates that the two chip layouts are dissimilar, and the two chip layouts are clustered into different initial clusters. In this manner, the plurality of chip layouts may be clustered into a plurality of initial clusters, and each initial cluster includes at least one chip layout. In all embodiments of the present disclosure, each initial cluster is used as a cluster, thereby clustering the plurality of chip layouts into a plurality of clusters. The distance formula is not limited in all embodiments of the present disclosure. For example, the distance formula is a formula of a Euclidean spatial distance or a formula of a cosine distance. A value of the distance threshold may be set based on experience. In all embodiments of the present disclosure, the quantity of clusters is preset, such as N. N is a positive integer. The K-means clustering algorithm is used for clustering the plurality of chip layouts, based on the layout features.

In all embodiments of the present disclosure, step 503 includes step 5031 to step 5034.

Step 5031: Obtain a plurality of first layout features from the layout features, each of first layout features indicating a clustering center. For example, each of first layout features indicates a clustering center of a first cluster.

A manner in which the electronic device obtains the first layout feature is not limited in all embodiments of the present disclosure. The quantity of clusters is preset, such as N. The quantity of first layout features is equal to the quantity of clusters. In all embodiments of the present disclosure, a plurality of first layout features is selected randomly from the layout features. In all embodiments of the present disclosure, the plurality of first layout features may be configured on the electronic device. Alternatively, a user may input the plurality of first layout features into the electronic device. Alternatively, the electronic device may cluster the plurality of chip layouts into a plurality of initial clusters ramdomly, and average, for each initial cluster, layout features of chip layouts included in the initial cluster to obtain a result indicating the average layout feature of chip layouts included in the respective initial cluster, and use an obtained result as one first layout feature. In this case, a quantity of first layout features is the same as a quantity of initial clusters. Alternatively, in a manner of step 5031 to step 5038, a plurality of times of clustering are performed on the plurality of chip layouts, a plurality of clusters are obtained after the last time of clustering in the plurality of times of clustering, layout features of chip layouts included in the clusters are averaged, and obtained results are used as first layout features. One first layout feature is an expected clustering center of one first cluster, and may indicate a clustering center of the first cluster.

Step 5032: Calculate distances between the layout features of the chip layouts and the first layout features. For example, a distance between a layout feature of a chip layout and a first layout feature may be calculated according to the formula of the Euclidean spatial distance or the formula of the cosine distance.

Step 5033: Select, for each chip layout, a minimum first distance from distances between a layout feature of a respective chip layout and the first layout features, and cluster the respective chip layout into a first cluster comprising a first layout feature corresponding to the first distance.

In all embodiments of the present disclosure, a smaller distance between the layout feature of the chip layout and the first layout feature indicates that the layout feature of the chip layout is more similar to the first layout feature, and both the layout feature of the chip layout and the first layout feature are more capable of representing the same type of chip layout. Based on this principle, the minimum first distance may be selected from the distances between the layout feature of the any chip layout and the first layout features. The first layout feature corresponding to the first distance is a first layout feature that is in the first layout features and that is most similar to the layout feature of the chip layout. The chip layout may be clustered into the first cluster comprising the first layout feature corresponding to the first distance.

In this manner, the plurality of chip layouts may be clustered into a plurality of first clusters. Chip layouts in the same first cluster correspond to the same type of chip layout. Therefore, in this manner, the chip layouts may be clustered based on types of the chip layouts.

Step 5034: Use each first cluster as a respective cluster of the plurality of clusters in a case that each first cluster meets a clustering end condition.

That any first cluster meets the clustering end condition is not limited in all embodiments of the present disclosure. For example, that any first cluster meets the clustering end condition is as follows: A quantity of clustering times corresponding to the first cluster reaches a specified quantity of times. For example, if a quantity of clustering times corresponding to a first cluster is 50, and reaches the specified quantity of times, the first cluster meets the clustering end condition. The following further describes another implementation in which any first cluster meets the clustering end condition. Details are not described herein again.

In all embodiments of the present disclosure, for any first cluster, an actual clustering center of the first cluster may be determined based on layout features of chip layouts in the first cluster. For example, an averaging operation is performed on layout features of chip layouts in an $i^{th}$ first cluster according to the following Formula (4), to obtain an actual clustering center of the first cluster:

$$\mu_i = \frac{1}{|C_i|} \sum_{x \in C_i} x \qquad \text{Formula (4)}$$

where $\mu_i$ represents the actual clustering center of the $i^{th}$ first cluster, $C_i$ represents a quantity of chip layouts included in the $i^{th}$ first cluster, X represents the layout feature of the chip layout, and $\Sigma$ is a function symbol of a summation function.

In all embodiments of the present disclosure, a first quantity of clustering times of clustering are performed on the plurality of chip layouts, and first clusters are obtained after the last time of clustering in clustering of the first quantity of clustering times. In this case, clustering of a quantity of clustering times obtained by subtracting one from the first quantity of clustering times may be completed for the plurality of chip layouts, and clusters are obtained after the last time of clustering in the clustering of the quantity of clustering times obtained by subtracting one from the first quantity of clustering times. In other words, M (M is a positive integer) times of clustering are performed on the plurality of chip layouts, and the last time of clustering in the M times of clustering is referred to as an $M^{th}$ time of clustering. In this case, first clusters are obtained after the $M^{th}$ time of clustering, and clusters are obtained after an $(M-1)^{th}$ time of clustering. In all embodiments of the present disclosure, an actual clustering center of each cluster may be obtained. If an error between the actual clustering center of each cluster and an actual clustering center of each first cluster falls within a specified range, it is determined that each first cluster meets the clustering end condition.

In another possible implementation, an error of any first cluster may be determined based on layout features of chip layouts in the first cluster and an actual clustering center of the first cluster, and a total clustering error is obtained by determining a sum of errors of the first clusters. In all embodiments of the present disclosure, according to the following Formula (5), a sum of squares of differences between layout features of chip layouts in the first cluster and an actual clustering center of the first cluster is calculated, to obtain an error of the first cluster, and a sum of errors of the first clusters is used as a total clustering error:

$$\text{Error} = \sum_{i=1}^{N} \sum_{x \in C_i} |x - \mu_i|^2 \qquad \text{Formula (5)}$$

where Error represents the total clustering error, N represents a quantity of first clusters, $\mu_i$ represents an actual cluster center of an $i^{th}$ first cluster, $C_i$ represents a quantity of chip layouts included in the $i^{th}$ first cluster, X represents the layout feature of the chip layout, and $\Sigma$ is a function symbol of a summation function.

In a possible implementation, when a total clustering error of the first clusters is less than a specified total error, it is determined that each first cluster meets the clustering end condition. Alternatively, a first quantity of clustering times of clustering are performed on the plurality of chip layouts, to obtain first clusters. In this case, a total clustering error of clusters obtained after clustering of a quantity of clustering times obtained by subtracting one from the first quantity of clustering times is performed on the chip layouts may be obtained. If a difference between the total clustering error of the clusters and the total clustering error of the first clusters falls within a specified range, it is determined that each first cluster meets the clustering end condition.

When each first cluster meets the clustering end condition, each first cluster is used as each cluster.

In all embodiments of the present disclosure, after step 5033, the method further includes step 5035 to step 5038.

Step 5035: Determine, for each first cluster in a case that a respective first cluster does not meet the clustering end condition, a second layout feature based on layout features of chip layouts in the respective first cluster, the second layout feature representing a clustering center of a respective second cluster.

That respective first cluster does not meet the clustering end condition is equivalent to that a first cluster that does not meet the clustering end condition exists in the plurality of first clusters. In this case, an actual clustering center of each first cluster may be determined based on layout features (namely, layout features) of chip layouts in the any first cluster, and the actual clustering center of the first cluster is used as one second layout feature. The second layout feature is an expected clustering center of one second cluster, and may represent a clustering center of the second cluster.

Step 5036: Calculate distances between the layout features (namely, the layout features) of the chip layouts and second layout features. For example, a distance between a layout feature of any chip layout and any second layout feature may be calculated according to the formula of the Euclidean spatial distance or the formula of the cosine distance.

Step 5037: Select, for each chip layout, a minimum second distance from distances between a layout feature of a respective chip layout and the second layout features, and cluster the respective chip layout into a second cluster comprising a second layout feature corresponding to the second distance.

A smaller distance between the layout feature of the chip layout and the second layout feature indicates that the layout feature of the chip layout is more similar to the second layout feature, and both the layout feature of the chip layout and the second layout feature are more capable of representing the same type of chip layout. Based on this principle, the minimum second distance may be selected from the distances between the layout feature of the any chip layout and the second layout features. The second layout feature corresponding to the second distance is a second layout feature that is in the second layout features and that is most similar to the layout feature of the chip layout. The chip layout may be clustered into the second cluster corresponding to the second layout feature corresponding to the second distance.

In this manner, the plurality of chip layouts may be clustered into a plurality of second clusters. Chip layouts in the same second cluster correspond to the same type of chip layout. Therefore, in this manner, the chip layouts may be clustered based on types of the chip layouts.

Step 5038: Use each second cluster as a respective cluster of the plurality of clusters in a case that each second cluster meets the clustering end condition.

When each second cluster meets the clustering end condition, each second cluster is used as each cluster. When each second cluster does not meet the clustering end condition, the plurality of chip layouts may be clustered again in a manner of step 5035 to step 5038, until each cluster is obtained.

The plurality of chip layouts are clustered for a plurality of times in a manner of step 5031 to step 5038, so that a clustering center of a cluster can be continuously changed, chip layouts in the same cluster are more similar, and chip layouts in different clusters are more dissimilar, until the clustering end condition is met. That the clustering end condition is met is equivalent to that the cluster is converged, and the clustering center of the cluster does not fluctuate any more. Therefore, the cluster obtained by clustering the plurality of chip layouts for a plurality of times in the manner of step 5031 to step 5038 has a small an error and high accuracy.

Step 504: Screen, for each cluster, one or more key chip layouts from chip layouts of the respective cluster.

In all embodiments of the present disclosure, the chip layouts included in the cluster belong to the same chip layout type. Therefore, the key chip layout may be obtained by randomly sampling the chip layouts included in the any cluster. There is at least one key chip layout. The chip layouts are clustered to obtain the clusters, and the key chip layout is obtained, through screening, from chip layouts included in each cluster. This can avoid manually selecting the key chip layout from all the chip layouts, and avoid interference of manual experience, random selection, and the like to a final result.

In a possible implementation, step 504 includes: obtaining distances between layout features of the chip layouts in each cluster and a clustering center of a respective cluster; and evenly sampling, based on the distances between the layout features of the chip layouts in the respective cluster and the clustering center of the respective cluster, the chip layouts comprised in the respective cluster, to obtain a plurality of key chip layouts.

In all embodiments of the present disclosure, a clustering center of any cluster may be an expected clustering center of the cluster, or may be an actual clustering center of the cluster. For a calculation manner of the expected clustering center of the cluster, refer to determining content about the second layout feature. Implementation principles thereof are similar. For a calculation manner of the actual cluster center of the cluster, refer to determining content about the actual cluster center of the first cluster. Implementation principles thereof are similar.

For any cluster, a distance between a layout feature of any chip layout included in the cluster and a clustering center of the cluster may be calculated according to the formula of the Euclidean spatial distance or the formula of the cosine distance. In this manner, distances between layout features of chip layouts in the cluster and the clustering center of the cluster may be obtained.

In all embodiments of the present disclosure, a maximum distance is determined from the distances between the layout features of the chip layouts in the cluster and the clustering center of the cluster, and the maximum distance is divided by a sampling quantity to obtain a sampling interval. A sampling distance that is an integer multiple of the sampling interval is obtained, through screening, from the distances between the layout features of the chip layouts in the cluster and the clustering center of the cluster. A key chip layout is obtained, through sampling, from a chip layout corresponding to the sampling distance.

For example, it is assumed that there are M clusters, and the sampling quantity is L+1. For any cluster, a maximum distance is determined from distances between layout features of chip layouts in the cluster and a clustering center of the cluster, and the maximum distance is divided by L+1 to obtain a sampling interval. Sampling distances that are 0, 1*sampling interval, 2*sampling interval, ..., (L+1)*sampling interval are obtained, through screening, from the distances between the layout features of the chip layouts in the cluster and the clustering center of the cluster, and the maximum distance. A total of L+2 chip layouts are obtained, through sampling, from chip layouts corresponding to these sampling distances. A layout feature of a chip layout corresponding to the sampling distance 0 is the clustering center of the cluster, and a distance between a layout feature of a chip layout corresponding to the sampling distance "(L+1)*sampling interval" and the clustering center of the cluster is the maximum distance. Because L+2 chip layouts may be obtained from one cluster through sampling, a total of M×(L+2) chip layouts may be obtained from the M clusters through sampling.

In a possible implementation, after step 504, the method further includes: performing source mask optimization on each key chip layout to obtain a source and a mask layout corresponding to the respective key chip layout; and performing mask optimization on another chip layout based on the source, to obtain a mask layout corresponding to the another chip layout, the another chip layout being a chip layout other than the key chip layout in the chip layouts.

In all embodiments of the present disclosure, performing source mask optimization on the key chip layout is equivalent to performing source mask optimization (SMO) on the key chip layout, so that the source and the mask layout corresponding to the key chip layout can be obtained. SMO is a key resolution enhancement technology for implementing a nanometer (for example, 28 nanometers or even smaller) integrated circuit. The key chip layout is obtained from the chip layouts through screening, and SMO is performed on the key chip layout, so that a quantity of key chip layouts can be less than a quantity of chip layouts, thereby improving a speed of SMO. In addition, the chip layouts are clustered, and the key chip layout is obtained, through screening, from chip layouts included in each cluster. This can ensure that the key chip layout covers various chip layout types, and the key chip layout has less redundancy phenomenon, so that accuracy of the source obtained by performing SMO on the key chip layout is high, and efficiency and an effect of SMO are improved.

SMO belongs to a source optimization (SO) technology. Wherein source optimization (SO) adjusts the incidence angles or intensity distributions of light rays emitted from the illumination system. Mask optimization (MO) regulates the amplitude of the transmitted light rays via mask. All embodiments of the present disclosure can apply well known SMO technology. By changing intensity distribution of a source, the SMO technology may adjust intensity and a direction of incident light, so that quality of an imaging layout obtained by exposing the mask layout on a wafer by using the source is high, thereby helping improve chip yield. When SMO is performed on the key chip layout based on the method In all embodiments of the present disclosure, a speed and an effect of SMO can be improved. In all embodiments of the present disclosure, photolithography resolution can be improved, and a photolithography process window can be increased. In addition, the chip layout in all embodiments of the present disclosure is a layout represented by pixels. Therefore, the chip layout has high universality, and may be applicable to chip layout types such as a contact hole type, a logical layout type, and a dense line type.

When any time of SMO is performed, any source may be used as an initial source, and a lithography machine is invoked to expose the key chip layout on photosensitive adhesive based on the initial source to obtain an mask layout. Then, the lithography machine is invoked to expose the mask layout on a wafer by using the initial source, to obtain an imaging layout. The imaging layout is compared with the key chip layout, to obtain an error between the imaging layout and the key chip layout.

In all embodiments of the present disclosure, if the error between the imaging layout and the key chip layout meets an optimization condition, the initial source is used as the source, the intermediate mask layout is used as the mask layout corresponding to the key chip layout, and the mask layout corresponding to the key chip layout is configured for invoking the lithography machine to expose, on the wafer by using the source, the mask layout corresponding to the key chip layout, to obtain the imaging layout corresponding to the key chip layout. If the error between the imaging layout and the key chip layout does not meet the optimization condition, the initial source is adjusted based on the error between the imaging layout and the key chip layout to obtain an adjusted initial source. The adjusted initial source is used as an initial source of a next time of SMO, and the foregoing SMO is performed at least once based on the initial source, until a target source and the mask layout corresponding to the key chip layout are obtained.

In all embodiments of the present disclosure, that the optimization condition is met is that the error between the imaging layout and the key chip layout falls within a specified error range. Alternatively, that the optimization condition is met is that a gradient of the error between the imaging layout and the key chip layout is less than a specified gradient threshold. In this case, when the initial source is adjusted based on the error between the imaging layout and the key chip layout, the initial source may be adjusted based on the gradient of the error between the imaging layout and the key chip layout.

Then, the lithography machine may be invoked to expose the another chip layout on the photosensitive adhesive based on the source, to obtain the mask layout corresponding to the another chip layout. The mask layout corresponding to the another chip layout is configured for invoking the lithography machine to expose, on the wafer by using the source, the mask layout corresponding to the another chip layout, to obtain the imaging layout corresponding to the another chip layout.

In all embodiments of the present disclosure, if the key chip layout and the another chip layout are obtained by dividing one chip layout, after source mask optimization is performed on the key chip layout to obtain the source, the lithography machine may be invoked to expose the chip layout on the photosensitive adhesive based on the source, to obtain a mask layout corresponding to the chip layout. The mask layout corresponding to the chip layout is configured for invoking the lithography machine to expose, on the wafer by using the source, the mask layout corresponding to the chip layout, to obtain an imaging layout corresponding to the chip layout.

Information (including but not limited to user device information, user personal information, and the like), data (including but not limited to data used for analysis, stored data, and displayed data), and a signal in this application are authorized by a user or fully authorized by each party, and related data needs to be collected, used, and processed in compliance with relevant national laws and standards. For example, the chip layout in this application is obtained in case of full authorization.

According to the foregoing method, the chip layout encoder focuses on extracting a layout feature that can distinguish between chip layout types. Therefore, when the chip layout encoder is configured to extract the layout features of the chip layouts, and perform clustering on the plurality of chip layouts based on the layout features of the chip layouts, chip layouts of the same chip layout type can be accurately clustered into the same cluster, and chip layouts of different chip layout types are clustered into different clusters, thereby improving accuracy of a clustering result. When the key chip layout is obtained, through screening, from chip layouts included in any cluster, redundancy of the key chip layout can be reduced, and screening quality can be improved.

The foregoing describes, from the perspective of method steps, the method for training a chip layout encoder and the chip layout screening method provided in the embodiments of this application. The following further describes the method with reference to FIG. 6. FIG. 6 is a schematic diagram of a chip layout encoder and perform cluster screening based on the chip layout encoder according to an embodiment of this application.

In all embodiments of the present disclosure, a sample data set may be obtained, and a chip layout encoder is obtained by training an initial encoder by using the sample data set based on the method for training a chip layout encoder related to FIG. 2. The sample data set In all embodiments of the present disclosure includes two open-source data sets. One data set includes 4877 chip layouts, and the 4877 chip layouts may be used as sample chip layouts or a part of chip layouts may be extracted from the 4877 chip layouts as sample chip layouts. The other data set includes 5394 chip layouts, and the 5394 chip layouts may be used as sample chip layouts or a part of chip layouts may be extracted from the 5394 chip layouts as sample chip layouts. The sample chip layout is configured for training the initial encoder. In addition, the sample data set In all embodiments of the present disclosure further includes some chip layouts of a contact hole type, some chip layouts of a logical layout type, some chip layouts of a dense line type, and the like.

After the chip layout encoder is obtained through training, a key chip layout may be obtained from a plurality of chip layouts through screening by using the chip layout encoder. For a structure of the chip layout encoder, refer to descriptions related to FIG. 4. Details are not described herein again.

In all embodiments of the present disclosure, layout features of the chip layouts may be extracted by using the chip layout encoder. Then, the chip layouts are clustered based on the layout features of the chip layouts, to obtain a plurality of clusters. Any cluster includes at least one chip layout. Subsequently, a key chip layout is obtained from each cluster through screening. For example, for any cluster, a key chip layout may be obtained, through screening, from chip layouts included in the cluster.

The foregoing chip layout encoder focuses on extracting a layout feature that can distinguish between chip layout types. Therefore, when the encoder is configured to extract the layout features of the chip layouts, and perform clustering on the plurality of chip layouts based on the layout features of the chip layouts, accuracy of a clustering result can be improved. When the key chip layout is obtained from each cluster through screening, redundancy of the key chip layout can be reduced, and screening quality can be improved.

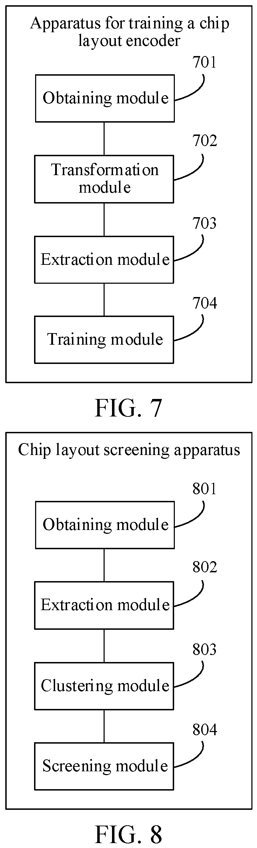

FIG. 7 is a schematic structural diagram of an apparatus for training a chip layout encoder according to an embodiment of this application. As shown in FIG. 7, the apparatus includes:

an obtaining module 701, configured to configured to obtain a sample chip layout and an initial encoder;

a transformation module 702, configured to perform geometric transformation on the sample chip layout to obtain at least one reference chip layout;

an extraction module 703, configured to extract a sample layout feature from the sample chip layout and a reference layout feature from each reference chip layout by the initial encoder; and

a training module 704, configured to train the initial encoder based on the sample layout feature and the reference layout feature to obtain a trained encoder.

In a possible implementation, the transformation module 702 is configured to: flip the sample chip layout to obtain a flipped chip layout; rotate the sample chip layout and the flipped chip layout to obtain two rotated chip layouts, the at least one reference chip layout comprising the flipped chip layout and the two rotated chip layouts.

In a possible implementation, the transformation module 702 is configured to: flip the sample chip layout to obtain a flipped chip layout, the at least one reference chip layout comprising the flipped chip layout; or rotate the sample chip layout to obtain a rotated chip layout, the at least one reference chip layout comprising the rotated chip layout.

In a possible implementation, the transformation module 702 is configured to: rotate the sample chip layout to obtain a rotated chip layout; and flip the sample chip layout and the rotated chip layout to obtain two flipped chip layouts, the at least one reference chip layout comprising the rotated chip layout and the two flipped chip layouts.

In a possible implementation, the extraction module 703 is configured to perform a plurality of times of downsampling on the sample chip layout by the initial encoder, to obtain a downsampling feature obtained through each time of downsampling, the sample layout feature being a downsampling feature obtained through a last time of downsampling.

In a possible implementation, the apparatus further includes:

a reconstruction module, configured to determine a reconstructed chip layout based on the layout feature of the sample chip layout, the reconstructed chip layout being a chip layout reconstructed based on the layout feature of the sample chip layout.

The training module 704 is configured to train the initial encoder based on the sample chip layout, the reconstructed chip layout, the sample layout feature, and the reference layout feature, to obtain the trained encoder.

In a possible implementation, the reconstruction module is configured to perform a plurality of times of upsampling on the sample layout feature to obtain an upsampling feature obtained through each time of upsampling, the reconstructed chip layout being a chip layout obtained based on an upsampling feature obtained through a last time of upsampling.

In a possible implementation, the reconstruction module is configured to: perform a first time of upsampling on the sample layout feature to obtain a first upsampling feature, the sample layout feature being obtained by performing a plurality of times of downsampling on the sample chip layout; and obtain, for each upsampling feature obtained through a respective time of upsampling, a downsampling feature corresponding to the respective upsampling feature, the downsampling feature corresponding to the respective upsampling feature being obtaining by a jth time of downsampling in the plurality of times of downsampling, the respective time of upsampling being an ith time of upsampling, a sum of i and j being a preset quantity of times; combine the respective upsampling feature with the downsampling feature corresponding to the respective upsampling feature, to obtain a combined feature corresponding to the respective upsampling feature; and perform upsampling on the combined feature corresponding to the respective upsampling feature, to obtain a next upsampling feature of the respective upsampling feature.

In a possible implementation, the training module 704 is configured to: determine a first loss based on the layout feature of the sample chip layout and the layout feature of each reference chip layout; determine a second loss based on the sample chip layout and the reconstructed chip layout; and train the initial encoder based on the first loss and the second loss to obtain the chip layout encoder.

According to the foregoing apparatus, geometric transformation is performed on the sample chip layout to obtain the reference chip layout, and the initial encoder is trained by using the layout feature of the sample chip layout and the layout feature of the reference chip layout to obtain the chip layout encoder. Therefore, the chip layout encoder can output similar layout features for chip layouts before and after geometric transformation. The chip layouts before and after geometric transformation belong to the same chip layout type. Therefore, the chip layout encoder focuses on extracting a layout feature that can distinguish between chip layout types. This helps improve clustering accuracy and reduces redundancy of a screening result when clustering and screening are subsequently performed on chip layouts based on the layout feature.

It is to be understood that, when the apparatus provided in FIG. 7 implements the functions thereof, only division of the foregoing function modules is used as an example for description. In the practical application, the functions may be allocated to and completed by different function modules according to requirements. That is, an internal structure of the device is divided into different function modules, to complete all or some of the functions described above. In addition, the apparatus provided in the foregoing embodiment belongs to the same concept as the method embodiment. For a specific implementation process thereof, refer to the method embodiment, and details are not described herein again.

FIG. 8 is a schematic structural diagram of a chip layout screening apparatus according to an embodiment of this application. As shown in FIG. 8, the apparatus includes:

an obtaining module 801, configured to obtain a plurality of chip layouts and a chip layout encoder (namely, a trained encoder), the chip layout encoder being obtained through training based on the foregoing method for training a chip layout encoder;

an extraction module 802, configured to extract layout features from the chip layouts by the trained encoder;

a clustering module 803, configured to cluster the plurality of chip layouts based on the layout features, to obtain a plurality of clusters, each cluster comprising at least one chip layout; and

a screening module 804, configured to screen, for each cluster, one or more key chip layouts from chip layouts of the respective cluster.

In a possible implementation, the clustering module 803 is configured to: obtain a plurality of first layout features from the layout features, each of first layout features indicating a clustering center; calculate distances between the layout features and the first layout features; select, for each chip layout, a minimum first distance from distances between a layout feature of a respective chip layout and the first layout features, and cluster the respective chip layout into a first cluster comprising a first layout feature corresponding to the first distance; and use each first cluster as a respective cluster of the plurality of clusters in a case that each first cluster meets a clustering end condition.

In a possible implementation, the clustering module 803 is further configured to: determine, for each first cluster in a case that a respective first cluster does not meet the clustering end condition, a second layout feature based on layout features of chip layouts in the respective first cluster, the second layout feature representing a clustering center of a respective second cluster; calculate distances between the layout features of the chip layouts and second layout features; select, for each chip layout, a minimum second distance from distances between a layout feature of a respective chip layout and the second layout features, and cluster the respective chip layout into a second cluster comprising a second layout feature corresponding to the second distance; and use each second cluster as a respective cluster of the plurality of clusters in a case that each second cluster meets the clustering end condition.

In a possible implementation, the screening module 804 is configured to: obtain distances between layout features of the chip layouts in each cluster and a clustering center of a respective cluster; and evenly sample, based on the distances between the layout features of the chip layouts in the respective cluster and the clustering center of the respective cluster, the chip layouts comprised in the respective cluster, to obtain a plurality of key chip layouts.

In a possible implementation, the apparatus further includes:
an optimization module, configured to: perform source mask optimization on each key chip layout to obtain a source and a mask layout corresponding to the respective key chip layout; and perform mask optimization on another chip layout based on the source, to obtain a mask layout corresponding to the another chip layout, the another chip layout being a chip layout other than the key chip layout in the chip layouts.

According to the foregoing apparatus, the chip layout encoder focuses on extracting a layout feature that can distinguish between chip layout types. Therefore, when the chip layout encoder is configured to extract the layout features of the chip layouts, and perform clustering on the plurality of chip layouts based on the layout features of the chip layouts, chip layouts of the same chip layout type can be accurately clustered into the same cluster, and chip layouts of different chip layout types are clustered into different clusters, thereby improving accuracy of a clustering result. When the key chip layout is obtained, through screening, from chip layouts included in any cluster, redundancy of the key chip layout can be reduced, and screening quality can be improved.

It is to be understood that, when the apparatus provided in FIG. 8 implements the functions thereof, only division of the foregoing function modules is used as an example for description. In the practical application, the functions may be allocated to and completed by different function modules according to requirements. That is, an internal structure of the device is divided into different function modules, to complete all or some of the functions described above. In addition, the apparatus provided in the foregoing embodiment belongs to the same concept as the method embodiment. For a specific implementation process thereof, refer to the method embodiment, and details are not described herein again.

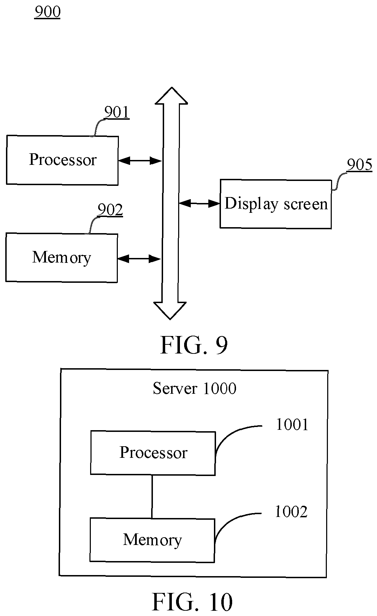

FIG. 9 is a structural block diagram of a terminal device 900 according to an exemplary embodiment of this application. The terminal device 900 includes: a processor 901 and a memory 902.

The processor 901 may include one or more processing cores, for example, a 4-core processor or an 8-core processor. The processor 901 may be implemented in at least one hardware form of a digital signal processor (DSP), a field-programmable gate array (FPGA), and a programmable logic array (PLA). The processor 901 may alternatively include a main processor and a coprocessor. The main processor is configured to process data in an active state, also referred to as a central processing unit (CPU). The coprocessor is a low-power processor configured to process data in a standby state. In all embodiments of the present disclosure, the processor 901 may be integrated with a graphics processing unit (GPU). The GPU is configured to render and draw content that needs to be displayed on a display screen. In all embodiments of the present disclosure, the processor 901 may further include an artificial intelligence (AI) processor. The AI processor is configured to process computing operations related to machine learning.

The memory 902 may include one or more computer-readable storage media. The computer-readable storage medium may be non-transient. The memory 902 may further include a high-speed random access memory and a non-volatile memory, for example, one or more disk storage devices or flash storage devices. In all embodiments of the present disclosure, the non-transient computer readable storage medium in the memory 902 is configured to store at least one computer program, and the at least one computer program is configured to be executed by the processor 901, so that the terminal device 900 implements the method for training a chip layout encoder or the chip layout screening method provided in the method embodiment of this application.

In all embodiments of the present disclosure, the terminal device 900 further includes: a display screen 905.

The display screen 905 is configured to display a user interface (UI). The UI may include a graph, text, an icon, a video, and any combination thereof. When the display screen 905 is a touch display screen, the display screen 905 further has a capability of collecting a touch signal on or above a surface of the display screen 905. The touch signal may be inputted into the processor 901 as a control signal for processing. In this case, the display screen 905 may be further configured to provide a virtual button and/or a virtual keyboard that are/is also referred to as a soft button and/or a soft keyboard. In all embodiments of the present disclosure, there may be one display screen 905 that is disposed on a front panel of the terminal device 900. In other embodiments, there may be at least two display screens 905 that are respectively disposed on different surfaces of the terminal 900 or that are folded. In still other embodiments, the display screen 905 may be a flexible display screen that is disposed on a curved surface or a folded surface of the terminal device 900. Even, the display screen 905 may be further disposed in a non-rectangular irregular pattern, namely, a special-shaped screen. The display screen 905 may be prepared by using materials such as a liquid crystal display (LCD), an organic light-emitting diode (OLED), or the like. For example, chip layouts such as a sample chip layout, a rotary chip layout, and a symmetric chip layout are displayed by using the display screen 905.

A person skilled in the art may understand that the structure shown in FIG. 9 does not constitute a limitation on the terminal device 900, and may include more or fewer components than those shown in the figure, or combine some components, or use different component arrangements.

FIG. 10 is a schematic structural diagram of a server according to an embodiment of this application. The server 1000 may have vary greatly due to different configurations or performance, and may include one or more processors 1001 and one or more memories 1002. The one or more memories 1002 store at least one computer program, and the at least one computer program is loaded and executed by the one or more processors 1001, so that the server 1000 implements the method for training a chip layout encoder or the chip layout screening method provided in the foregoing method embodiments. For example, the processor 1001 is a CPU. Certainly, the server 1000 may further include components such as a wired or wireless network interface, a keyboard, and an input/output interface, to perform input/output. The server 1000 may further include another component configured to implement a device function. Details are not described herein.

In an exemplary embodiment, a non-volatile computer-readable storage medium is further provided, storing at least one computer program, the at least one computer program being loaded and executed by a processor, so that an electronic device implements any one of the foregoing training methods for a chip layout encoder or the foregoing chip layout screening methods.

In all embodiments of the present disclosure, the computer-readable storage medium may be a read-only memory (ROM), a random access memory (RAM), a compact disc read-only memory (CD-ROM), a magnetic tape, a floppy disk, an optical data storage device, or the like.

In an exemplary embodiment, a computer program is further provided, there being at least one computer program, and the at least one computer program being loaded and executed by a processor, so that an electronic device implements any one of the foregoing training methods for a chip layout encoder or the foregoing chip layout screening methods.

In an exemplary embodiment, a computer program product is further provided, having at least one computer program stored therein, the at least one computer program being loaded and executed by a processor, so that an electronic device implements any one of the foregoing training methods for a chip layout encoder or the foregoing chip layout screening methods.

It is to be understood that "plurality of" mentioned in the specification means two or more. "And/or" describes an association relationship of an associated object, indicating that three relationships may exist. For example, A and/or B may indicate: A exists alone, both A and B exist, and B exist alone. The character "/" generally indicates an "or" relationship between associated objects before and after the character.

The sequence numbers of the foregoing embodiments of this application are merely for description purpose, and are not intended to indicate priorities of the embodiments.

The foregoing descriptions are merely exemplary embodiments of this application, but are not intended to limit this application. Any modification, equivalent replacement, or improvement made within the principle of this application shall fall within the protection scope of this application.

**Claims**

1.    A method for training a chip layout encoder, executable by an electronic device, the method comprising:

    obtaining a sample chip layout and an initial encoder;
    performing geometric transformation on the sample chip layout to obtain at least one reference chip layout;
    extracting a sample layout feature from the sample chip layout and a reference layout feature from each reference chip layout by the initial encoder; and
    training the initial encoder based on the sample layout feature and the reference layout feature to obtain a trained encoder.

2.    The method according to claim 1, wherein the performing the geometric transformation on the sample chip layout to obtain at least one reference chip layout comprises:

    flipping the sample chip layout to obtain a flipped chip layout; and

rotating the sample chip layout and the flipped chip layout to obtain two rotated chip layouts, the at least one reference chip layout comprising the flipped chip layout and the two rotated chip layouts.

3. The method according to claim **1,** wherein the performing the geometric transformation on the sample chip layout to obtain at least one reference chip layout comprises:

flipping the sample chip layout to obtain a flipped chip layout, the at least one reference chip layout comprising the flipped chip layout; or
rotating the sample chip layout to obtain a rotated chip layout, the at least one reference chip layout comprising the rotated chip layout.

4. The method according to claim 1, wherein the performing the geometric transformation on the sample chip layout to obtain at least one reference chip layout comprises:

rotating the sample chip layout to obtain a rotated chip layout; and
flipping the sample chip layout and the rotated chip layout to obtain two flipped chip layouts, the at least one reference chip layout comprising the rotated chip layout and the two flipped chip layouts.

5. The method according to any one of claims 1 to 4, wherein the extracting the sample layout feature from the sample chip layout by the initial encoder comprises:
performing a plurality of times of downsampling on the sample chip layout by the initial encoder, to obtain a downsampling feature obtained through each time of downsampling, the sample layout feature being a downsampling feature obtained through a last time of downsampling.

6. The method according to claim 5, wherein the performing a plurality of times of downsampling on the sample chip layout by the initial encoder, to obtain a downsampling feature obtained through each time of downsampling comprises:

performing a first time of downsampling on the sample chip layout by the initial encoder, to obtain a first downsampling feature; and
performing, for each downsampling feature obtained through a respective time of downsampling, a next time of downsampling on the respective downsampling feature by the initial encoder, to obtain a downsampling feature obtained through the next time of downsampling.

7. The method according to any one of claims 1 to 6, wherein the method further comprises:

determining a reconstructed chip layout based on the sample layout feature; and
the training the initial encoder based on the sample layout feature and the reference layout feature to obtain a trained encoder comprises:
training the initial encoder based on the sample chip layout, the reconstructed chip layout, the sample layout feature, and the reference layout feature, to obtain the trained encoder.

8. The method according to claim 7, wherein the determining a reconstructed chip layout based on the sample layout feature comprises:
performing a plurality of times of upsampling on the sample layout feature to obtain an upsampling feature obtained through each time of upsampling, the reconstructed chip layout being a chip layout obtained based on an upsampling feature obtained through a last time of upsampling.

9. The method according to claim 8, wherein the performing a plurality of times of upsampling on the sample layout feature to obtain an upsampling feature obtained through each time of upsampling comprises:

performing a first time of upsampling on the sample layout feature to obtain a first upsampling feature, the sample layout feature being obtained by performing a plurality of times of downsampling on the sample chip layout;
obtaining, for each upsampling feature obtained through a respective time of upsampling, a downsampling feature corresponding to the respective upsampling feature, the downsampling feature corresponding to the respective upsampling feature being obtaining by a jth time of downsampling in the plurality of times of downsampling, the respective time of upsampling being an ith time of upsampling, a sum of i and j being a preset quantity of times;

combining the respective upsampling feature with the downsampling feature corresponding to the respective upsampling feature, to obtain a combined feature corresponding to the respective upsampling feature; and performing upsampling on the combined feature corresponding to the respective upsampling feature, to obtain a next upsampling feature of the respective upsampling feature.

10. The method according to claim 7, wherein the training the initial encoder based on the sample chip layout, the reconstructed chip layout, the sample layout feature, and the reference layout feature, to obtain the trained encoder comprises:

determining a first loss based on the sample layout feature and the reference layout feature;
determining a second loss based on the sample chip layout and the reconstructed chip layout; and
training the initial encoder based on the first loss and the second loss to obtain the trained encoder.

11. A chip layout screening method, executable by an electronic device, the method comprising:

obtaining a plurality of chip layouts and a trained encoder, the trained encoder being obtained through the method for training a chip layout encoder according to any one of claims 1 to 10;
extracting layout features from the chip layouts by the trained encoder;
clustering the plurality of chip layouts based on the layout features, to obtain a plurality of clusters, each cluster comprising at least one chip layout; and
screening for each cluster, one or more key chip layouts from chip layouts of the respective cluster.

12. The method according to claim 11, wherein the clustering the plurality of chip layouts based on the layout features, to obtain a plurality of clusters, each cluster comprising at least one chip layout comprises:

obtaining a plurality of first layout features from the layout features, each of first layout features indicating a clustering center;
calculating distances between the layout features and the first layout features;
selecting, for each chip layout, a minimum first distance from distances between a layout feature of a respective chip layout and the first layout features;
clustering the respective chip layout into a first cluster comprising a first layout feature corresponding to the first distance; and
using each first cluster as a respective cluster of the plurality of clusters in a case that each first cluster meets a clustering end condition.

13. The method according to claim 12, wherein the method further comprises:

determining, for each first cluster in a case that a respective first cluster does not meet the clustering end condition, a second layout feature based on layout features of chip layouts in the respective first cluster, the second layout feature representing a clustering center of a respective second cluster;
calculating distances between the layout features and second layout features;
selecting, for each chip layout, a minimum second distance from distances between a layout feature of a respective chip layout and the second layout features;
clustering the respective chip layout into a second cluster comprising a second layout feature corresponding to the second distance; and
using each second cluster as a respective cluster of the plurality of clusters in a case that each second cluster meets the clustering end condition.

14. The method according to any one of claims 11 to 13, wherein the screening, for each cluster, one or more key chip layouts from chip layouts of a respective cluster comprises:

obtaining distances between layout features of the chip layouts in each cluster and a clustering center of a respective cluster; and
evenly sampling, based on the distances between the layout features of the chip layouts in the respective cluster and the clustering center of the respective cluster, the chip layouts comprised in the respective cluster, to obtain a plurality of key chip layouts.

15. The method according to any one of claims 11 to 14, further comprising:

performing source mask optimization on each key chip layout to obtain a source and a mask layout corresponding to the respective key chip layout; and

performing mask optimization on another chip layout based on the source, to obtain a mask layout corresponding to the another chip layout, the another chip layout being a chip layout other than the key chip layout in the chip layouts.

16. An apparatus for training a chip layout encoder, comprising:

an obtaining module, configured to obtain a sample chip layout and an initial encoder;

a transformation module, configured to perform geometric transformation on the sample chip layout to obtain at least one reference chip layout;

an extraction module, configured to extract a sample layout feature from the sample chip layout and a reference layout feature from each reference chip layout by the initial encoder; and

a training module, configured to train the initial encoder based on the sample layout feature and the reference layout feature to obtain a trained encoder.

17. A chip layout screening apparatus, comprising:

an obtaining module, configured to obtain a plurality of chip layouts and a trained encoder, the trained encoder being obtained through the method for training a chip layout encoder according to any one of claims 1 to 10;

an extraction module, configured to extract layout features from the chip layouts by the trained encoder;

a clustering module, configured to cluster the plurality of chip layouts based on the layout features, to obtain a plurality of clusters, each cluster comprising at least one chip layout; and

a screening module, configured to screen, for each cluster, one or more key chip layouts from chip layouts of the respective cluster.

18. An electronic device, comprising a processor and a memory, the memory storing at least one computer program, and the at least one computer program being loaded and executed by the processor, so that the electronic device implements the method for training a chip layout encoder according to any one of claims 1 to 10 or implements the chip layout screening method according to any one of claims 11 to 15.

19. A non-volatile computer-readable storage medium, storing at least one computer program, the at least one computer program being loaded and executed by a processor, so that an electronic device implements the method for training a chip layout encoder according to any one of claims 1 to 10 or implements the chip layout screening method according to any one of claims 11 to 15.

20. A computer program product, having at least one computer program stored therein, the at least one computer program being loaded and executed by a processor, so that an electronic device implements the method for training a chip layout encoder according to any one of claims 1 to 10 or implements the chip layout screening method according to any one of claims 11 to 15.

21. A computer program, there being at least one computer program, and the at least one computer program being loaded and executed by a processor, so that an electronic device implements the method for training a chip layout encoder according to any one of claims 1 to 10 or implements the chip layout screening method according to any one of claims 11 to 15.

102

101

101

## FIG. 1

201

Obtain a sample chip layout and an initial encoder

202

Perform geometric transformation on the sample chip layout to obtain at least one reference chip layout

203

Extract a sample layout feature from the sample chip layout and a reference layout feature from each reference chip layout by the initial encoder

204

Train the initial encoder based on the sample layout feature and the reference layout feature to obtain a trained encoder

## FIG. 2

Sample
chip
layout

Rightward
flipping

Symmetric
chip layout

Rotate
by 45
degrees

Rotate
by 45
degrees

Rotary
chip
layout

Rotary
chip
layout

Rotate
by 45
degrees

Rotate
by 45
degrees

Rotary
chip
layout

Rotary
chip
layout

FIG. 3

FIG. 4

Obtain a plurality of chip layouts and a trained encoder  — 501

Extract layout features of the chip layouts by the trained encoder  — 502

Cluster the plurality of chip layouts based on the layout features, to obtain a plurality of clusters, each cluster including at least one chip layout  — 503

Screen, for each cluster, one or more key chip layouts from chip layouts of the respective cluster  — 504

FIG. 5

Chip layout encoder

Extract layout features of chip layouts

Cluster the chip layouts

Obtain a key chip layout from each target cluster through screening

Layout feature

Clustering

Screening

Cluster

Key chip layout

FIG. 6

Apparatus for training a chip
layout encoder

701

Obtaining module

702

Transformation
module

703

Extraction module

704

Training module

FIG. 7

Chip layout screening apparatus

801

Obtaining module

802

Extraction module

803

Clustering module

804

Screening module

FIG. 8

900

901

Processor

902

Memory

905

Display screen

## FIG. 9

Server 1000

Processor

1001

Memory

1002

## FIG. 10

| INTERNATIONAL SEARCH REPORT | International application No. |
|---|---|
| | **PCT/CN2023/097408** |

**A. CLASSIFICATION OF SUBJECT MATTER**

G06V10/40(2022.01)i; G06V10/762(2022.01)i

According to International Patent Classification (IPC) or to both national classification and IPC

**B. FIELDS SEARCHED**

Minimum documentation searched (classification system followed by classification symbols)

IPC:G06V10/-; G06K9/-

Documentation searched other than minimum documentation to the extent that such documents are included in the fields searched

Electronic data base consulted during the international search (name of data base and, where practicable, search terms used)

CNTXT, ENTXTC, VEN, ENTXT, IEEE, CJFD: 集成电路, 版图, 编码器, 旋转, 镜像, 翻转, 一致性, 损失函数, 特征, 提取, 图片, 图像, 芯片, 距离, 采样, 聚类, feature, extract+, flip+, rotat+, cluster+, distance, image, picture, loss function, consistency loss, sample+, u-net, encod+, integrated circuit layout

**C. DOCUMENTS CONSIDERED TO BE RELEVANT**

| Category* | Citation of document, with indication, where appropriate, of the relevant passages | Relevant to claim No. |
|---|---|---|
| X | CN 112418321 A (BEIJING WODONG TIANJUN INFORMATION TECHNOLOGY CO., LTD. et al.) 26 February 2021 (2021-02-26) description, paragraphs [0046]-[0094] | 1-6, 16, 18-21 |
| Y | CN 112418321 A (BEIJING WODONG TIANJUN INFORMATION TECHNOLOGY CO., LTD. et al.) 26 February 2021 (2021-02-26) description, paragraphs [0046]-[0094] | 11-15, 17 |
| Y | US 2021319227 A1 (INTERNATIONAL BUSINESS MACHINES CORPORATION) 14 October 2021 (2021-10-14) description, paragraphs [0018]-[0026] | 11-15, 17 |
| A | CN 108535952 A (BEIJING INSTITUTE OF TECHNOLOGY) 14 September 2018 (2018-09-14) entire document | 1-21 |
| A | CN 110187609 A (BEIJING INSTITUTE OF TECHNOLOGY) 30 August 2019 (2019-08-30) entire document | 1-21 |

☑ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **04 September 2023** | **07 September 2023** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

International application No.

**PCT/CN2023/097408**

**C.** **DOCUMENTS CONSIDERED TO BE RELEVANT**

| Category* | Citation of document, with indication, where appropriate, of the relevant passages | Relevant to claim No. |
|---|---|---|
| A | CN 111353411 A (SICHUAN YIFEISHI TECHNOLOGY CO., LTD.) 30 June 2020 (2020-06-30)<br>entire document | 1-21 |
| A | CN 111445396 A (CHINA ELECTRONIC PRODUCT RELIABILITY AND ENVIRONMENTAL TESTING RESEARCH INSTITUTE ((FIFTH ELECTRONIC RESEARCH INSTITUTE OF MIIT) (CHINA CEPREI LABORATORY))) 24 July 2020 (2020-07-24)<br>entire document | 1-21 |
| A | CN 111898619 A (SHANGHAI EYE CONTROL TECHNOLOGY CO., LTD.) 06 November 2020 (2020-11-06)<br>entire document | 1-21 |
| A | US 2022156886 A1 (ADOBE INC.) 19 May 2022 (2022-05-19)<br>entire document | 1-21 |

Form PCT/ISA/210 (second sheet) (July 2022)

| Patent document cited in search report | | | Publication date (day/month/year) | Patent family member(s) | | | Publication date (day/month/year) |
| :--- | :--- | :--- | :--- | :--- | :--- | :--- | :--- |
| CN | 112418321 | A | 26 February 2021 | None | | | |
| US | 2021319227 | A1 | 14 October 2021 | WO | 2021209835 | A1 | 21 October 2021 |
| | | | | GB | 2612707 | A | 10 May 2023 |
| | | | | DE | 112021002291 | T5 | 16 March 2023 |
| | | | | JP | 2023520631 | A | 18 May 2023 |
| | | | | US | 11164005 | B1 | 02 November 2021 |
| | | | | CN | 115280378 | A | 01 November 2022 |
| | | | | CN | 115280378 | B | 22 August 2023 |
| CN | 108535952 | A | 14 September 2018 | CN | 108535952 | B | 11 August 2020 |
| CN | 110187609 | A | 30 August 2019 | CN | 110187609 | B | 21 August 2020 |
| CN | 111353411 | A | 30 June 2020 | None | | | |
| CN | 111445396 | A | 24 July 2020 | None | | | |
| CN | 111898619 | A | 06 November 2020 | None | | | |
| US | 2022156886 | A1 | 19 May 2022 | None | | | |

**REFERENCES CITED IN THE DESCRIPTION**

**Patent documents cited in the description**

- CN 202211176018